# EUROPEAN PATENT APPLICATION

(11) **EP 2 781 553 A1**
(43) Date of publication of application: **24.09.2014**
(21) Application number: 12849830.0
(22) Date of filing: 15.11.2012
(51) Int. Cl.: C08L 83/08, C08G 77/388, C08K 3/00, C08K 5/18, C08L 63/00, C09K 3/10, H01L 23/29, H01L 23/31

(54) **SILANE-CONTAINING COMPOSITION, CURABLE RESIN COMPOSITION, AND SEALING MATERIAL**

(30) Priority: 15.11.2011 JP 2011249936; 26.06.2012 JP 2012143564; 26.06.2012 JP 2012143565; 28.06.2012 JP 2012145681; 05.07.2012 JP 2012151655
(71) Applicant: Nippon Shokubai Co., Ltd., Osaka-shi, Osaka 541-0043 (JP)
(72) Inventor: SUGIOKA Takuo, Suita-shi Osaka 564-8512 (JP); KONOSU Osamu, Suita-shi Osaka 564-8512 (JP); FUJIBAYASHI Teruhisa, Suita-shi Osaka 564-8512 (JP); OKADA Atsushi, Suita-shi Osaka 564-8512 (JP); KAMATA Shusuke, Suita-shi Osaka 564-8512 (JP); WADA Takaaki, Suita-shi Osaka 564-8512 (JP)
(74) Representative: Hart-Davis, Jason
(86) International application number: PCT/JP2012/079624
(87) International publication number: WO 2013/073606

(57) **Abstract**

The present invention provides a silane-containing composition and a curable resin composition that can provide a cured product extremely high in mechanical strength and glass transition temperature, and that is useful as a material for a sealing material of a mounting substrate or the like, as well as a sealing material using the same. It also provides a method for suitably obtaining such a silane-containing composition. The present invention provides a silane-containing composition including an aromatic amine compound and a silane compound, wherein the aromatic amine compound is a compound having a melting point of 100°C or higher, and the silane compound has a siloxane bond and is represented by a specified average composition formula.

## Description

### TECHNICAL FIELD

The present invention relates to a silane-containing composition, a curable resin composition and a sealing material. More specifically, it relates to a silane-containing composition useful in various industrial fields including electric and mechanical fields, as well as a curable resin composition and a sealing material using the same.

### BACKGROUND ART

A silane-containing composition is a composition containing a silane compound including silicon as a constituent atom, and has been conventionally widely used for raw materials of various industrial products. The silane-containing composition is currently studied to be applied to various applications because of its characteristics due to a bond via silicon, such as a siloxane bond, and is being utilized in various industrial fields including electric and mechanical fields with being mixed with a curable resin composition, for example.

The curable resin composition is a composition including a resin that has such a property as to be cured by light or heat, and each curable resin composition is used which has physical properties required in each of applications in various industrial fields including electric and mechanical fields. One application of such a curable resin composition is a sealing material for use in a substrate on which electronic components, semiconductor chips and the like are mounted. When electronic components, semiconductor chips and the like are mounted on a substrate, a surface mounting system is often adopted as a mounting system because of being capable of high density mounting, wherein a sealing material having electrical insulating properties is used for sealing, and as such a sealing material, a resin composition is generally used which includes an epoxy resin and a phenol compound as a curing agent of the epoxy resin as organic main components.

With respect to a conventional curable resin composition, for example, Patent Literature 1 discloses an epoxy resin composition including an epoxy resin, a reaction product of an organosiloxane with a given epoxy resin, silica and a curing agent, and describes that a novolac phenol resin is preferable as the curing agent. Patent Literature 2 discloses a semiconductor sealing epoxy resin composition, including an epoxy resin, a phenol resin curing agent, an inorganic filling material and a curing accelerator. In addition, Patent Literature 3 discloses a semiconductor sealing material resin composition, containing an epoxy resin, a phenol resin acting as a curing agent of the epoxy resin, a metal hydroxide and an organophosphorus compound.

Meanwhile, an aromatic amine compound has been conventionally known as one crosslinking agent (curing agent) of an epoxy resin. When the aromatic amine compound is used to cure an epoxy resin, the resulting cured product is high in strength and glass transition temperature (Tg), and thus is widely used for airplanes, automobiles, CFRPs (carbon fiber reinforced plastics) for sports, and the like. For example, Patent Literature 4 describes that when an aromatic amine is used as a curing agent of an epoxy resin in a prepreg including carbon fibers and a thermosetting resin such as an epoxy resin, a cured resin good in heat resistance can be obtained. In addition, Patent Literature 5 discloses a method of using an epoxy resin composition including an epoxy resin, N,N-diglycidylaniline and diaminodiphenylsulfone/diaminodiphenylmethane to mold carbon fiber reinforced plastics.

A few techniques in which the aromatic amine compound is used in a sealing material application have also been studied. For example, Patent Literature 6 discloses a liquid epoxy resin composition including a liquid epoxy resin, an aromatic amine-based curing agent containing an aromatic amine compound of a specified structure, an inorganic filling agent and a perfluoroalkyl group-containing silicone oil, wherein examples of the aromatic amine compound of a specified structure include diethyltoluenediamine, dimethyltoluenediamine and dimethyltoluenediamine. In addition, Patent Literature 7 discloses a low-viscosity semiconductor sealing epoxy resin composition, including an epoxy resin, an aromatic amine as a curing agent of the epoxy resin, a metal complex, a coupling agent and a silane compound, wherein examples of the aromatic amine include diethyltoluenediamine and 4,4'-methylenebis(2-ethylaniline). Furthermore, Patent Literature 8 discloses a liquid under filling resin composition, including an epoxy resin, an amine-based curing agent and an inorganic filling agent, wherein examples of the amine-based curing agent include an aromatic amine-based compound.

### CITATION LIST

### - Patent Literatures

Patent Literature 1: JP 2-102217 A
Patent Literature 2: JP 9-316176 A
Patent Literature 3: JP 2001-234037 A
Patent Literature 4: JP 2010-280904 A
Patent Literature 5: JP 63-90539 A
Patent Literature 6: JP 2006-290949 A
Patent Literature 7: JP 2008-255178 A
Patent Literature 8: JP 2010-239031 A

### SUMMARY OF INVENTION

### - Technical Problem

As described above, usually, the resin composition including an epoxy resin and a phenol compound as a curing agent of the epoxy resin as organic main components is generally used as the sealing material of a mounting substrate, and the resin composition is usually used with being mixed with a larger amount of an inorganic filling material (for example, silica filler) for the purpose of preventing the warpage of the substrate after curing from being generated. In the production process of such a sealing material, while the inorganic filling material is needed to be highly filled and thus the epoxy resin and the phenol compound as organic main components are molten and kneaded (mixed) with a molten silica filler by using a twin-screw extruder or the like, the temperature at the melting (melting temperature) is often set to 100°C or lower in order to avoid the crosslinking reaction of the epoxy resin being advanced at the melting temperature, and it is believed that the epoxy resin and the phenol compound as organic main components preferably have a lower melting point. Therefore, the cured product does not have a sufficient heat resistance (resistance to thermal decomposition), and there has been room for improvement in order to obtain a cured product excellent in heat resistance.

On the other hand, it is known that the aromatic amine compound is utilized as the crosslinking agent of the epoxy resin, as described above. However, the aromatic amine compound often has a melting point of 100°C or higher to cause the crosslinking reaction of the epoxy resin to rapidly occur at the melting temperature, and there is thus extremely few cases where the aromatic amine compound is mixed with the sealing material resin composition, in view of the production process of the sealing material. Even if the aromatic amine compound is utilized, only aromatic amine compounds having a low melting point such as the compounds exemplified in Patent Literatures 6 to 8 are utilized, and characteristics of utilizing of the aromatic amine compound as the crosslinking agent of the epoxy resin, namely, characteristics where a cured product to be obtained exhibits a high strength and high Tg cannot be exerted as much as possible. Herein, the liquid resin compositions as described in Patent Literatures 6 and 8 have many limitations about transportation and storage form, and had room for improvement in terms of handling ability and workability.

The present invention has been made under the above circumstances, and an object thereof is to provide a silane-containing composition and a curable resin composition that can provide a cured product extremely high in mechanical strength and glass transition temperature and excellent in heat resistance, and that is useful as a material for a sealing material of a mounting substrate or the like, as well as a sealing material using the same. Another object of the present invention is to provide a method for suitably obtaining such a silane-containing composition.

### - Solution to Problem

The present inventors have intensively studied about a material that can be preferably applied to a sealing material of a mounting substrate or the like, and have found that a silane-containing composition including a silane compound of a specified structure and an aromatic amine compound having a melting point of 100°C or higher, in particular, a silane-containing composition in which the silane compound is uniformly dispersed in the aromatic amine compound has such a specific property that while the composition has excellent characteristics of the aromatic amine compound and the silane compound, the melting point of the aromatic amine compound disappears and the composition can be softened at a temperature of 100°C or lower. Then, the present inventors have found that such a silane-containing composition is preferable as a curing agent of an epoxy resin and can be preferably applied to a usual production process of a sealing material, and have found that a curable resin composition including the silane-containing composition, an epoxy resin and an inorganic filling material can provide a cured product extremely high in strength and high in glass transition temperature, and excellent in heat resistance, in particular, a cured product preferable as a sealing material. The present inventors have also found that when the silane-containing composition is produced, a production method including a step of dissolving the aromatic amine compound in a silane compound solution including the silane compound and a solvent, and then removing the solvent can be adopted to thereby allow the silane compound to be uniformly dispersed in the aromatic amine compound, preferably providing a silane-containing composition in which the silane compound and the aromatic amine compound are not merely mixed but integrated, and have conceived to be able to excellently solve the above problems, leading to the present invention.

That is, the present invention provides a silane-containing composition including an aromatic amine compound and a silane compound, wherein the aromatic amine compound is a compound having a melting point of 100°C or higher, and the silane compound has a siloxane bond and is represented by the following average composition formula (1) :

XₐY_{b}Z_{c}SiO_{d} (1)

wherein each X is the same or different and represents an organic backbone including an imide bond, each Y is the same or different and represents at least one selected from the group consisting of a hydrogen atom, a hydroxyl group, a halogen atom and an OR group, each R is the same or different, represents at least one group selected from the group consisting of an alkyl group, an acyl group, an aryl group and an unsaturated aliphatic residue, and optionally has a substituent, each Z is the same or different and represents an organic backbone including no imide bond, a is 0 or a number of less than 3, b is 0 or a number of less than 3, c is 0 or a number of less than 3, d is a number of less than 2 but not 0, and a + b + c + 2d = 4 is satisfied.

The present invention also provides a method for producing the silane-containing composition, the method including a step of dissolving the aromatic amine compound in a silane compound solution including the silane compound and a solvent, and then removing the solvent.

The present invention also provides a curable resin composition including the silane-containing composition, an epoxy resin and an inorganic filling material.

The present invention further provides a method for producing a cured product from the curable resin composition, the method including a step of subjecting the curable resin composition to molding, and a step of post-curing the resulting molded product, wherein a temperature at the post-curing is higher than a molding temperature by 30°C or higher.

The present invention also provides a sealing material obtained by using the curable resin composition.

The present invention will be described below in detail. It is to be noted that combinations of two, or three or more of preferable embodiments of the present invention described in paragraphs below are also preferable embodiments of the present invention.

### [Silane-Containing Composition]

The silane-containing composition of the present invention includes the aromatic amine compound and the silane compound, wherein each of such components can be used singly or in combination of two or more. The silane-containing composition can also include other components as long as it includes such components as essential components.

In such a silane-containing composition, preferably the silane compound is uniformly dispersed in the aromatic amine compound, and particularly preferably the silane compound and the aromatic amine compound are not merely mixed but integrated.

The silane-containing composition is also preferably solid at room temperature (20°C). When the silane-containing composition is solid at room temperature, it is good in handling ability and workability, and also has advantages in storing and transporting.

The silane-containing composition preferably has a heat softening temperature (also referred to as a softening point) of 100°C or lower. The softening point is preferably 100°C or lower because even when the silane-containing composition is used as, for example, a curing agent of an epoxy group-containing compound, progressing of the crosslinking reaction of the epoxy group-containing compound is suppressed at the melting temperatures of the silane-containing composition and the epoxy group-containing compound. The softening point is more preferably 98°C or lower and further preferably 95°C or lower.

The softening point (°C) is a value measured according to JIS K7234 (1986), and can be measured by using, for example, a heat softening temperature measuring apparatus (product name "ASP-MG4" manufactured by Meitec Corporation).

### <Aromatic Amine Compound>

In the silane-containing composition, the aromatic amine compound is a compound having a melting point of 100°C or higher. If the aromatic amine compound is a compound having a melting point of less than 100°C, a cured product obtained by using the silane-containing composition cannot have sufficiently enhanced strength and Tg, and a cured product excellent in heat resistance cannot be sometimes obtained. The melting point of the aromatic amine compound is preferably 102°C or higher, more preferably 105°C or higher, and further preferably 110°C or higher. In addition, the upper limit of the melting point of the aromatic amine compound is preferably 200°C or lower. Thus, the aromatic amine compound can be sufficiently mixed with the silane compound at the molecular level, and therefore the effect of the present invention can be more sufficiently exerted. The upper limit is more preferably 190°C or lower.

In the present specification, the melting point means a temperature (°C) at which a crystal is molten under an inert atmosphere to be liquid. Accordingly, an amorphous compound and a compound that is liquid at room temperature have no melting point.

The melting points of the aromatic amine compound and the silane-containing composition can be measured by, for example, differential scanning calorimetry (DSC).

The aromatic amine compound is an amine compound whose structure has an aromatic ring backbone, and examples include a primary amine compound, a secondary amine compound and a tertiary amine compound, but a primary amine compound and/or a secondary amine compound is preferably used. The number of amino groups in one molecule is not particularly limited, but is, for example, preferably 1 to 10 and more preferably 2 to 4.

The molecular weight of the aromatic amine compound is preferably 100 to 1000, for example. If the aromatic amine compound is a macromolecular compound having a molecular weight of more than 1000, it cannot be sufficiently mixed with the silane compound in some cases. In addition, if the molecular weight is less than 100, the aromatic amine compound is a compound substantially having no aromatic ring backbone, and sometimes does not have a sufficient resistance to thermal decomposition. The molecular weight is more preferably 100 to 800 and further preferably 100 to 600.

Examples of the aromatic amine compound include the following compound:

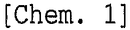

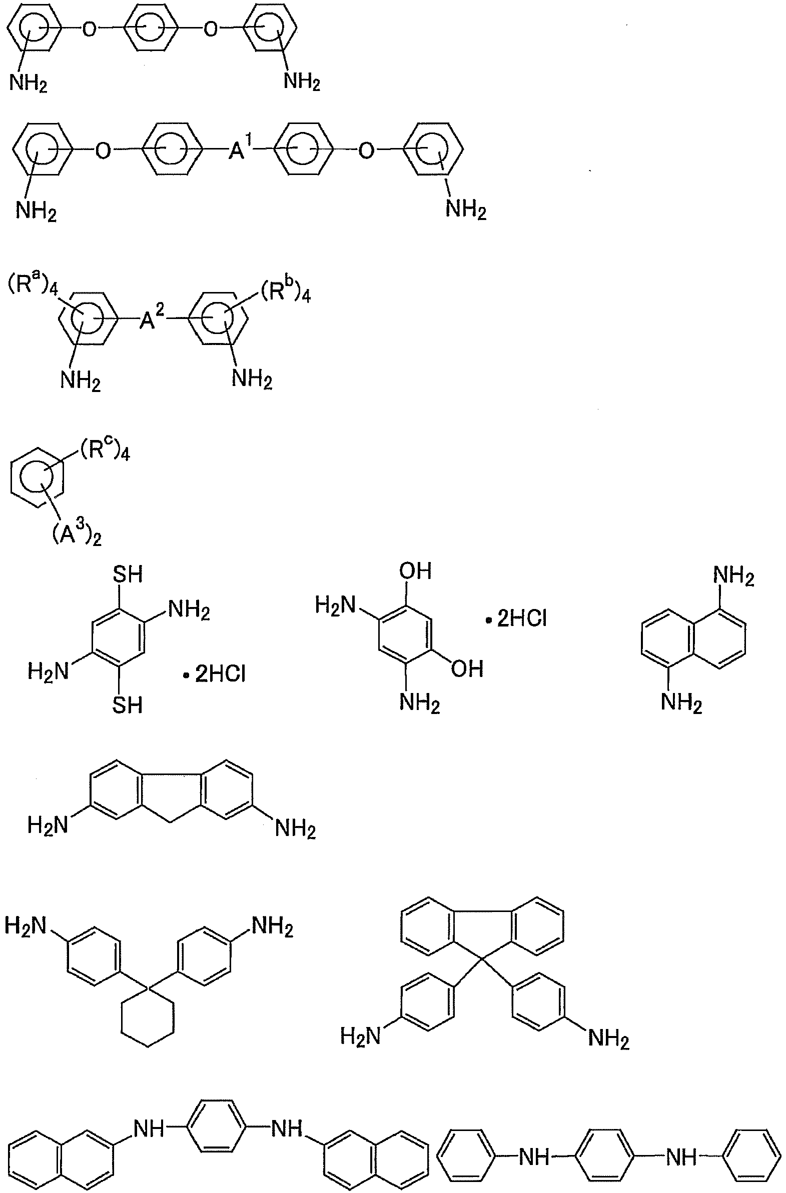

wherein A¹ represents a direct bond (-), -C(CF₃)₂-, - C(CH₃)₂- or -SO₂-. A² represents a direct bond (-), - C(CF₃)₂-, -C(CH₃)₂-, -S-, -SO₂-, -0- or -(CH₂)ₚ-. p is a number of 1 or more, and preferably a number of, for example, 1 to 5. Each A³ is the same or different and represents an amino group (-NH₂) or a methylamino group (- CH₂NH₂). R^{a} and R^{b} are the same or different and represent a hydrogen atom (-H), a methyl group (-CH₃), an amino group (-NH₂) or a fluorine atom (-F). Each R^{c} is the same or different and represents a hydrogen atom (-H) or a methyl group (-CH₃).

### <Silane Compound>

In the silane-containing composition, the silane compound has a siloxane bond (Si-O-Si bond) and is the compound represented by the average composition formula (1). Herein, such a silane compound is also referred to as a siloxane compound.

The silane-containing composition includes the silane compound, thereby making it possible to provide a cured product excellent in heat resistance, pressure resistance, mechanical/chemical stability and heat conductivity. For example, structures such as a siloxane backbone and an organic backbone including an imide bond (X) can be appropriately selected to allow the compound to exhibit higher compatibility with various polymers, thereby easily imparting heat resistance, pressure resistance, and the like to the polymers. The polymers, to which heat resistance, pressure resistance, and the like are imparted, each can form a cured product having various physical properties less deteriorated even under a severe environment such as high-temperature and high-pressure, and thus can be preferably used in a mounting application and the like. Thus, the silane compound can be preferably used for a mechanical part material, an electric/electronic component material, an automobile part material, a civil engineering and construction material, a molding material, a material for paints and adhesives, and the like, and can also be used as a molding material for electronic materials, a material for inks, paints, vanishes, and adhesives, and the like. Furthermore, the silane-containing composition can also be used as a low dielectric material for use in a semiconductor apparatus and the like, and a thermosetting resin composition for bond magnets. In particular, the silane-containing composition can be used in the mounting field, in which heat stability is required to be higher than that in a conventional home electronics application, such as a frontier microprocessing unit (MPU) and an in-car mounting material,.

In the silane compound, the siloxane backbone (also referred to as a main chain backbone) may be one essentially having a siloxane bond. Examples of the structure of such a siloxane backbone preferably include chain (linear or branched), ladder, network, cyclic, cage, and cubic structures. Among them, ladder, network, and cage structures are preferable because the silane compound easily exerts an effect even if being added in a small amount. That is, the silane compound preferably includes polysilsesquioxane. A cage structure is more preferable.

Herein, the proportion of the siloxane backbone in the silane compound is preferably 10 to 80% by mass in 100% by mass of the silane compound. The proportion is more preferably 15 to 70% by mass and further preferably 20 to 50% by mass.

In the average composition formula (1): XₐY_{b}Z_{c}SiO_{d}, while preferable X is as described later, Y preferably denotes a hydroxyl group or an OR group. Among them, Y more preferably denotes an OR group, and further preferably an OR group wherein R denotes an alkyl group having 1 to 8 carbon atoms.

In addition, Z preferably denotes at least one selected from the group consisting of an alkyl group, aromatic residues such as an aryl group and an aralkyl group, and an unsaturated aliphatic residue (these optionally having a substituent). Z more preferably denotes an alkyl group having 1 to 8 carbon atoms, or an aromatic residue such as an aryl group or an aralkyl group, optionally having a substituent. Specifically, for example, a methyl group, an ethyl group, a phenyl group, a vinyl group, a chloropropyl group, a mercaptopropyl group, an (epoxycyclohexyl)ethyl group, a glycidoxypropyl group, an N-phenyl-3-aminopropyl group, a (meth)acryloxypropyl group, a hexyl group, a decyl group, an octadecyl group, a trifluoropropyl group, and the like are preferable.

In the average composition formula (1), coefficient a of X is a number satisfying 0 ≤ a < 3, coefficient b of Y is a number satisfying 0 ≤ b < 3, coefficient c of Z is a number satisfying 0 ≤ c < 3, and coefficient d of O is a number satisfying 0<d<2.

In the present invention, the ratio of the organic backbone having an imide bond based on a silicon atom can be made higher to thereby enhance solubility of the silane compound in an organic resin. From such a viewpoint, coefficient a of X in the average composition formula (1) preferably satisfies 0 < a, more preferably satisfies 0.2 ≤ a. This makes the solubility in an organic resin higher, and when a resin composition in which the silane compound is dissolved in an organic resin is formed, the silane compound can more sufficiently exert characteristics thereof. Coefficient a of X more preferably satisfies 0.5 ≤ a, further preferably 0.7 ≤ a, particularly preferably 0.8 ≤ a, most preferably 1.0 ≤ a. From the viewpoint of the heat resistance of the silane compound, coefficient a of X preferably satisfies a ≤ 1.0. When coefficient a of X satisfies a ≤ 1.0, the heat resistance can be further enhanced.

Accordingly, coefficient a of X preferably satisfies 0.2 ≤ a ≤ 1.0 from the viewpoints of achieving a better heat resistance, enhancing the solubility in an organic resin, and achieving an excellent hydrolysis resistance. Coefficient a of X more preferably satisfies 0.5 ≤ a ≤ 1.0, further preferably 0.7 ≤ a ≤ 1.0, particularly preferably 0.8 ≤ a ≤ 1.0, most preferably a = 1.0.

In the average composition formula (1), a + b + c is preferably 0.5 or more, more preferably 0.7 or more, further preferably 0.7 or more and 1.0 or less, and particularly preferably 1. In addition, d, a coefficient of oxygen O, is preferably 1.50.

The silane compound can be represented by, for example, the following formula (2): 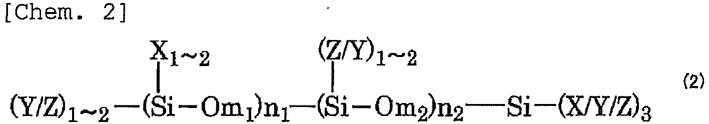 wherein X, Y and Z are each the same as described above. n₁ and n₂ represent the degree of polymerization. n₁ is a positive integer but not 0, and n₂ is 0 or a positive integer.

Herein, "Y/Z-" represents that Y or Z is bound, "X₁₋₂-" represents that one or two X(s) are bound, and "(Z/Y)₁₋₂-" represents that one Z or Y is bound, two Z(s) or Y(s) are bound, or one Z and one Y, two in total, are bound. "Si-(X/Y/Z)₃" represents that any three selected from X, Y and Z are bound to a silicon atom.

In the formula (2), Si-Oₘ₁ and Si-Oₘ₂ are not to define the order of Si-Oₘ₁ and Si-Oₘ₂, for example, a form where Si-Oₘ₁ and Si-Oₘ₂ are alternately or randomly co-condensed, and a form where a polysiloxane of Si-Oₘ₁ and a polysiloxane of Si-Oₘ₂ are bound are preferable, and any condensation structure may be adopted.

While the silane compound can be represented by the average composition formula (1), a siloxane backbone (main chain backbone essentially having a siloxane bond) in the silane compound can also be represented by (SiOₘ)ₙ. Structures other than such (SiOₘ)ₙ in the silane compound are structures: X representing an organic backbone including an imide bond (structure essentially having an imide bond); Y representing a hydrogen atom, a hydroxyl group or the like; and Z representing an organic backbone including no imide bond (also referred to as "organic group"); and these structures are bound to a silicon atom of the main chain backbone.

X, Y and Z may or may not be included in a repeating unit in the form of a "chain". For example, X may be included as a side chain by one or more in one molecule.

In (SiOₘ)ₙ, while n represents the degree of polymerization, the degree of polymerization represents the degree of polymerization in the main chain backbone, and n of the organic backbone(s) having an imide bond may not be necessarily present. In other words, one of the organic backbone having an imide bond may not be necessarily present in one unit of (SiOₘ)ₙ. In addition, although one or more organic backbones having an imide bond may be included in one molecule, if a plurality of the organic backbones are contained, two or more of the organic backbones having an imide bond may be bound to one silicon atom if included, as described above. The same shall apply hereafter.

In the main chain backbone (SiOₘ)ₙ, m is preferably a number of 1 or more and less than 2, and more preferably satisfies m = 1.5 to 1.8. Further preferably m = 1.5. In the main chain backbones (Si-Oₘ₁)ₙ₁ and (Si-Oₘ₂)ₙ₂ in the formula (2), the range of (n₁ + 1) / (n₁ + n₂ + 1) is preferably the same as a preferable range of a in the average composition formula (1). Furthermore, it is preferable that one Si atom be bound to (X/Y/Z)₃ in the formula (2) and one X be bound to a Si atom in (Si-Oₘ₁).
n represents the degree of polymerization, and is preferably 1 to 5000. More preferably is 1 to 2000, further preferably 1 to 1000, and particularly preferably 1 to 200. In addition, n is preferably 2 or more.

Examples of the silane compound wherein n is 2 include a form including two structural units, each structural unit including at least one organic backbone (X) having an imide bond bound to a silicon atom (hereinafter, also referred to as "structural unit (I)"), and a form including only one structural unit (I). Specifically, the following formula: 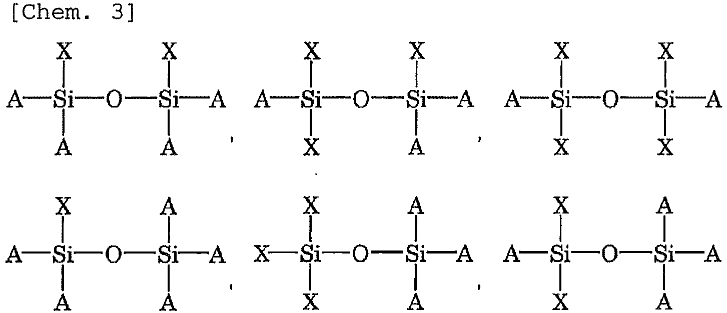 wherein A represents Y or Z, and X, Y and Z are each the same as described above; or the like is preferable, and examples include a homopolymer form having two identical structural units (I), a homopolymer form including two different structural units (I), and a copolymer form including only one structural unit (I) (co-condensation structure form).

At least one of X, Y and Z in the average composition formula (1) preferably has a polymerizable functional group. When the silane compound has at least one polymerizable functional group, the silane compound can be a polymer (resin component).

Examples of the polymerizable functional group include unsaturated hydrocarbon groups such as an alkenyl group and an alkynyl group, a hydroxyl group, a halogen atom, an amino group, a carboxyl group, an epoxy group, and an isocyanate group, but not limited thereto.

When X is represented by formula (3) described below and X has the polymerizable functional group, examples of X also include a form where at least one ring structure selected from the group consisting of an aromatic ring, a heterocyclic ring and an alicyclic ring, represented by R¹, has the polymerizable functional group as a substituent; and a form where at least one ring structure selected from the group consisting of an aromatic ring, a heterocyclic ring and an alicyclic ring, represented by R¹, is partially a polymerizable unsaturated hydrocarbon structure.

Also when X is represented by any of formulae (3-1) to (3-6) described below and X has the polymerizable functional group, examples of X similarly include a form where the ring structure has the polymerizable functional group as a substituent, and a form where the ring structure is partially a polymerizable unsaturated hydrocarbon structure.

In the average composition formula (1), X, representing the organic backbone including an imide bond, has an imide bond to thereby make the compatibility with the aromatic amine compound good. The ratio of such an organic backbone including an imide bond is preferably 20 to 100 mol per 100 mol of a silicon atom included in the silane compound. The proportion is more preferably 50 to 100 mol and further preferably 70 to 100 mol.

X in the average composition formula (1) preferably denotes a structural unit represented by the following formula (3) (group represented by the following formula (3)). That is, the silane compound in the present invention preferably includes a silane compound wherein X in the average composition formula (1) denotes a structural unit represented by the following formula (3):

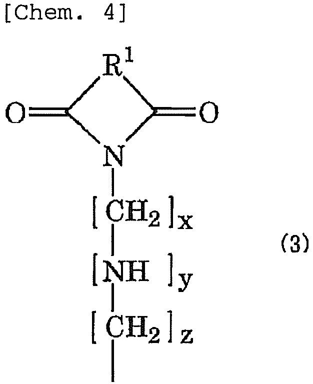

wherein R¹ represents at least one structure selected from the group consisting of an aromatic, a heterocyclic ring and an alicyclic ring optionally having a substituent. x and z are the same or different and are an integer of 0 or more and 5 or less, and y is 0 or 1. Such a silane compound is included to thereby further enhance the heat resistance of a cured product.

In the structural unit represented by the formula (3), x and z are the same or different and are an integer of 0 or more and 5 or less. Further, y is 0 or 1 and is preferably 0. x + z may be an integer of 0 or more and 10 or less but is preferably 3 to 7, more preferably 3 to 5, and particularly preferably 3.

In the formula (3), R¹ represents at least one structure selected from the group consisting of an aromatic, a heterocyclic ring and an alicyclic ring optionally having a substituent. The at least one structure selected from the group consisting of an aromatic, a heterocyclic ring and an alicyclic ring represents at least one group selected from the group consisting of a group having a ring structure of an aromatic compound (aromatic ring), a group having a ring structure of a heterocyclic compound (heterocyclic ring) and a group having a ring structure of an alicyclic compound (alicyclic ring).

Specifically, R¹ preferably denotes a phenylene group, a naphthyridine group, a divalent group of norbornene, an (alkyl) cyclohexylene group, a cyclohexenyl group, or the like.

The structural unit represented by the formula (3) is a structural unit represented by the following formula (3-1) when R¹ denotes a phenylene group, the structural unit is a structural unit represented by the following formula (3-2) when R¹ denotes an (alkyl) cyclohexylene group, the structural unit is a structural unit represented by the following formula (3-3) when R¹ denotes a naphthyridine group, the structural unit is a structural unit represented by the following formula (3-4) when R¹ denotes a divalent group of norbornene, and the structural unit is a structural unit represented by the following formula (3-5) when R¹ denotes a cyclohexenyl group.

When the aromatic, heterocyclic ring and alicyclic ring have a substituent, the substituent is preferably a halogen atom, a hydroxyl group, a methyl group, an ethyl group, a vinyl group, a chloropropyl group, a mercaptopropyl group, an (epoxycyclohexyl)ethyl group, a glycidoxypropyl group, an N-phenyl-3-aminopropyl group, a (meth)acryloxypropyl group, a hexyl group, a decyl group, an octadecyl group, a trifluoropropyl group, or the like.

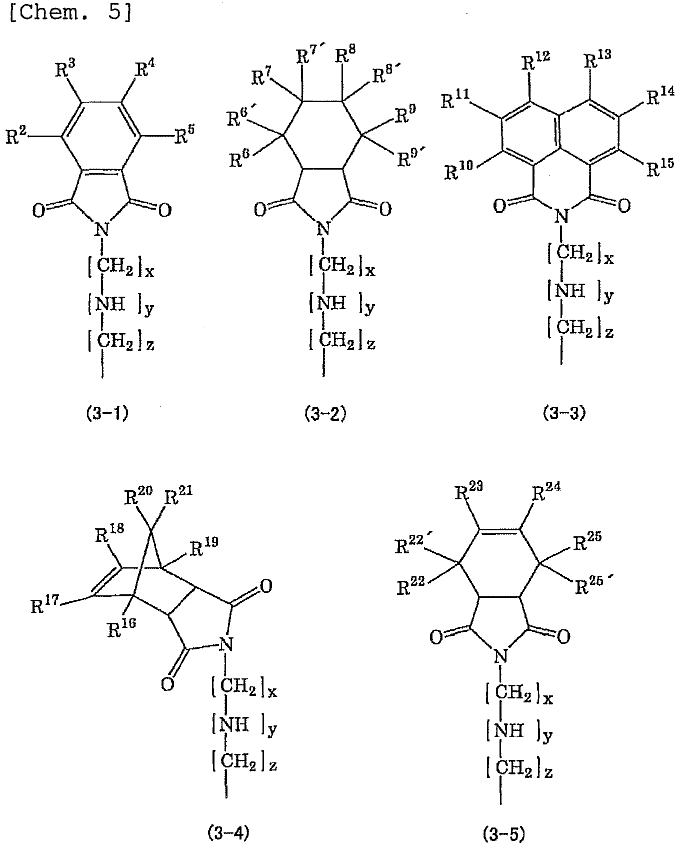

In the formulae (3-1) to (3-5), each of x, y and z is the same as that in the formula (3).

In the formula (3-1), R² to R⁵ are the same or different and represent at least one structure selected from the group consisting of a hydrogen atom, an alkyl group, a halogen atom and an aromatic. With respect to R² to R⁵ above preferable is a form where all of R² to R⁵ denote a hydrogen atom.

In the formula (3-2), R⁶ to R⁹ and R⁶' to R⁹' are the same or different and represent at least one structure selected from the group consisting of a hydrogen atom, an alkyl group, a halogen atom and an aromatic. With respect to R⁶ to R⁹ and R⁶' to R⁹' above, preferable is either a form where R⁷ or R⁸ denotes a methyl group and all of the rest denote a hydrogen atom, a form where all of R⁶ to R⁹ and R⁶' to R⁹' denote a hydrogen atom, or a form where all of R⁶ to R⁹ and R⁶' to R⁹' denote a fluorine atom. More preferable is a form where R⁷ or R⁸ denotes a methyl group and all of the rest denote a hydrogen atom.

In the formula (3-3), R¹⁰ to R¹⁵ are the same or different and represent at least one structure selected from the group consisting of a hydrogen atom, an alkyl group, a halogen atom and an aromatic. With respect to R¹⁰ to R¹⁵ above, preferable is a form where all denote a hydrogen atom or a form where all denote a fluorine atom. More preferable is a form where all denote a hydrogen atom.

In the formula (3-4), R¹⁶ to R²¹ are the same or different and represent at least one structure selected from the group consisting of a hydrogen atom, an alkyl group, a halogen atom and an aromatic. With respect to R¹⁶ to R²¹ above, preferable is a form where all denote a hydrogen atom, a form where all denote a fluorine atom, or a form where all denote a chlorine atom. More preferable is a form where all denote a hydrogen atom.

In the formula (3-5), R²² to R²⁵, R²²' and R²⁵' are the same or different and represent at least one structure selected from the group consisting of a hydrogen atom, an alkyl group, a halogen atom and an aromatic. With respect to R²² to R²⁵, R²²' to R²⁵' above preferable is either a form where all denote a hydrogen atom, a form where all denote a fluorine atom, or a form where all denote a chlorine atom. More preferable is a form where all denote a hydrogen atom.

When X denotes any of the structural units represented by the formulae (3-4) and (3-5), a silane compound having such X in the structure thereof has an unsaturated bond in the molecule and constructs a crosslinking structure in the same mechanism with a maleimide compound described later, and such a silane compound, which is mixed with the maleimide compound, can be thus used as a resin composition. Such a resin composition can exhibit excellent low dielectric properties because the crosslinking structure is a saturated ring structure and generates no polar group after crosslinking. Accordingly, such a resin composition is preferable as a resin composition for low dielectric materials. In particular, X preferably denotes the structural unit represented by the formula (3-4).

In the resin composition including the silane compound and the maleimide compound, a mixing ratio of the compounds (silane compound/maleimide compound) is preferably 10/90 to 90/10 in an equivalent ratio of both unsaturated bonds. The ratio is more preferably 15/85 to 85/15 and further preferably 20/80 to 80/20.

preferable application examples of the resin composition for low dielectric materials include a printed wiring substrate for high-speed computers or high-speed communication equipment, an antenna for wireless communications such as Wi-Fi, WiMAX, Bluetooth (R) and RF. tag, a printed wiring substrate for satellite broadcasting converters, a semiconductor package substrate, and a memory card. When a resin composition including the silane compound and an organic resin is used as a low dielectric material in such an application, a parasitic capacitance generated between electrodes forming electronic equipment can be suppressed, for example. Thus, for example, response properties can be improved and heat generation can be suppressed in the electronic equipment.

The resin composition for low dielectric materials preferably has a specific dielectric constant value (a relative permittivity value) of 3.4 or less as measured at a measurement frequency of 1 GHz or 5 GHz. The specific dielectric constant value is more preferably 3.2 or less and further preferably 3.1 or less. In addition, the resin composition preferably has a dielectric tangent value of 0.02 or less as measured at a measurement frequency of 1 GHz or 5 GHz. The dielectric tangent value is more preferably 0.01 or less and further preferably 0.009 or less. When the resin composition for low dielectric materials thus has a smaller specific dielectric constant value and/or a smaller dielectric tangent value, the resin composition can exhibit excellent characteristics when being used in the above applications.

When the above resin composition is a resin composition for low dielectric materials, the resin composition is preferably one in which the silane compound and the maleimide compound are mixed. Thus, the dielectric tangent value can be made smaller, and response properties can be improved and heat generation can be suppressed in electronic equipment used in a semiconductor package substrate or the like. The resin composition may further include other compounds in addition to the silane compound and the maleimide compound, and may include an epoxy resin, a phenol resin, or the like. The resin composition can include at least any of an epoxy resin and a phenol resin to thereby result in the more sufficient reduction in specific dielectric constant, exhibiting better characteristics as the resin composition for low dielectric materials.

When X in the average composition formula (1) denotes the structural unit represented by the formula (3), a structural unit represented by the following formula (3-6): 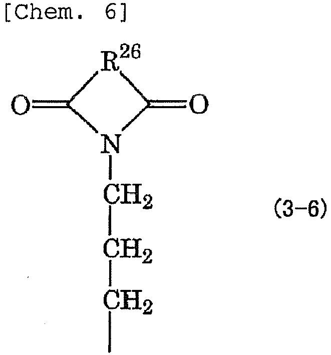 wherein R²⁶ represents at least one structure selected from the group consisting of an aromatic, a heterocyclic ring and an alicyclic ring; is particularly preferable as the structural unit represented by the formula (3). That is, the silane compound in the present invention preferably includes a silane compound where X in the average composition formula (1) denotes the structural unit represented by the formula (3-6). Herein, R²⁶ in the formula (3-6) preferably denotes the same as R¹ described in the formula (3). That is, x + z = 3 and y = 0 are preferably satisfied in the formula (3).

The silane compound is particularly preferably poly(γ-phthalimidopropylsilsesquioxane) where R²⁶ denotes a phenylene group, poly{γ-(hexahydro-4-methylphthalimido)propylsilsesquioxane} where R²⁶ denotes a methylcyclohexylene group, poly{γ-(1,8-naphthalimido)propylsilsesquioxane} where R²⁶ denotes a naphthyridine group, poly{γ-(5-norbornene-2,3-imido)propylsilsesquioxane} where R²⁶ denotes a divalent group of norbornene, or poly[(cis-4-cyclohexene-1,2-imido)propylsilsesquioxane] where R²⁶ denotes a cyclohexenyl group. The structures of these compounds can be identified by measurement using 1H-NMR, 13C-NMR, and MALDI-TOF-MS.

In the average composition formula (1), the number of bonds between a silicon atom to which X is bound and an oxygen atom is preferably 3. In this case, since the silicon atom to which X is bound is not bound to other functional group, a silane compound better in heat resistance, moisture resistance and hydrolysis resistance can be obtained. For example, when the silicon atom to which X is bound is bound to one oxygen and has other functional group, a silane compound further excellent in heat resistance, moisture resistance and hydrolysis resistance cannot be sometimes obtained depending on the type of the functional group. In addition, the number of bonds between the silicon atom constituting the siloxane bond and an oxygen atom is preferably 3. In this case, since the silicon atom constituting the siloxane bond is not bound to a functional group other than the organic group represented by X, a silane compound better in heat resistance and hydrolysis property can be obtained.

Examples of the molecular structure of the silane compound include chain structures (linear, branched), a ladder structure, cyclic structures including network, cyclic, and ladder structures, and a cage structure, but preferable structures are in particular ladder, network, and cage structures because the silane compound easily exerts an effect even in a small amount added. More preferable molecular structure is different depending on the effect demanded, and for example, a cage molecular structure can be adopted to thereby further reduce the viscosity of the silane-containing composition and remarkably realize the reduction in moisture adsorption in the cured product of the composition. That is, in order to realize more remarkable reductions in viscosity and moisture adsorption, a cage molecular structure is preferable and an embodiment in which the silane compound thus has a cage molecular structure is also one preferable embodiment of the present invention. The silane compound can have a cage molecular structure to thereby allow the silane-containing composition to have a remarkably reduced viscosity, allow the composition and the cured product thereof to be extremely excellent in low moisture adsorption property, and allow the cured product to have further enhanced mechanical strength and heat resistance, thereby allowing the cured product to be further useful in various applications (in particular, for example, an electronic component device of a semiconductor sealing material or the like). In addition, when the silane compound has a ladder structure, the reduction in moisture adsorption is less remarkable in the cured product of the silane-containing composition, but the silane-containing composition can have a further reduced viscosity and the cured product thereof can have a remarkably enhanced heat resistance. An embodiment in which the silane compound thus has a ladder molecular structure is also one preferable embodiment of the present invention.

Herein, the ladder, network, and cage molecular structures can be represented, for example, by the following structure formulae (a) to (f), wherein R represents an organic backbone represented by "XₐY_{b}Z_{c}" in the average composition formula (1).

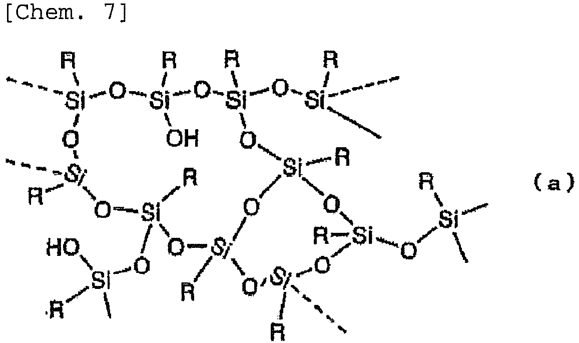

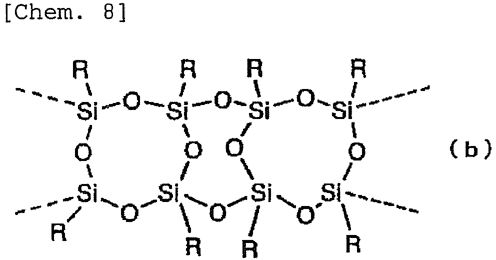

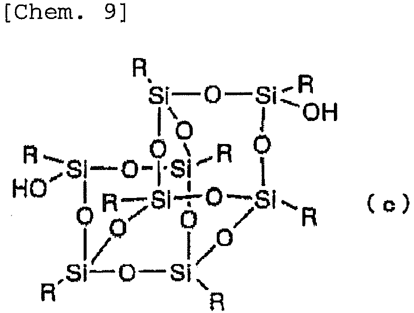

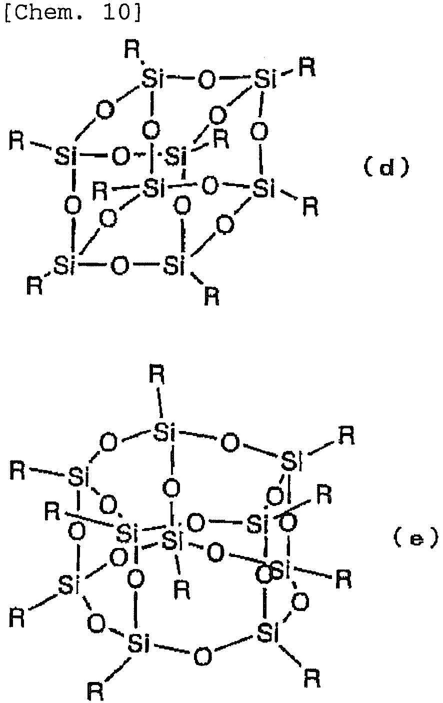

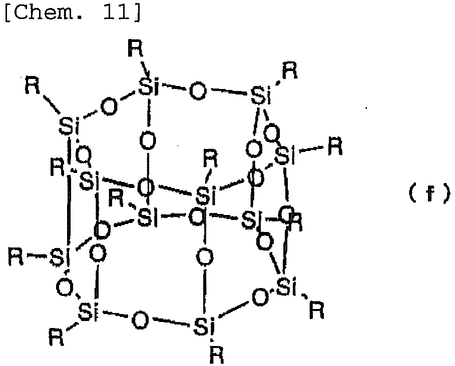

The structure formula (a) is a random (network) structure (Random structure), the structure formula (b) is a ladder structure (Ladder structure), the structure formula (c) is an incomplete cage structure (Incomplete condensed cage), and the structure formulae (d) to (f) are each a cage structure (Completely condensed structures).

As illustrated in the structure formulae (c) to (f), the silane compound having a cage molecular structure is preferably a form where an organic backbone layer corresponds to a shell portion and an inorganic backbone layer corresponds to a core portion.

The silane compound having a cage molecular structure is preferably a form where X in the average composition formula has a ring structure, and in particular, is preferably a form where such X is represented by the general formula (3). The silane compound is more preferably a form where R¹ in the general formula (3) denotes at least one structure selected from the group consisting of an aromatic ring, a saturated aliphatic cyclic hydrocarbon and an unsaturated aliphatic cyclic hydrocarbon. When such a silane compound is adopted, the function effect described above can be further sufficiently exerted, namely, the silane compound-containing composition has a remarkably reduced viscosity, and the composition and the cured product thereof are extremely excellent in low moisture adsorption property.

Herein, examples of the aromatic ring include benzene, biphenylene, terphenylene, naphthalene, anthracene, and penylene. Examples of the saturated aliphatic cyclic hydrocarbon include cyclobutane, cyclopentane, cyclohexane, cyclooctane, norbornane, and decahydronaphthalene. Examples of the unsaturated aliphatic cyclic hydrocarbon include cyclobutene, cyclopentene, cyclohexene, cyclooctene, and norbornene.

The silane compound having a cage molecular structure is further preferably a form where X represented by the general formula (3) denotes any of the structures represented by the general formulae (3-1) to (3-6), and particularly preferably a form where R¹ in the general formula (3) denotes any of a benzene ring and a norbornene structure.

One compound example included in a form where R¹ in the general formula (1) denotes a norbornene structure is shown in the following formula.

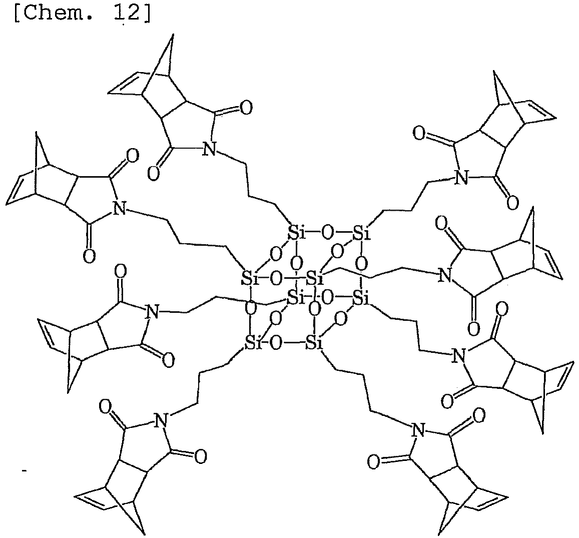

In the silane compound having a cage molecular structure, the ratio of the amount of a silanol group determined by the following expression (α) is more preferably 0.1 or less.

### [number of moles of Si-OH]/[number of moles of Si-O bond] (α)

Thus, the function effect described above can be further sufficiently exerted, namely, the silane compound-containing composition has a remarkably reduced viscosity, and the composition and the cured product thereof are extremely excellent in moisture adsorption resistance. The ratio is further preferably 0.05 or less and particularly preferably 0.01 or less. Most preferably, the silane compound has no remaining silanol group. In this case, in the average composition formula, a + b + c is preferably 0.5 or more. More preferably 0.7 or more, further preferably 0.7 or more and 1.0 or less, and particularly preferably 1. In addition, d, a coefficient of oxygen, is preferably 1.50.

The [number of moles of Si-OH bond] here is the number of bonds between Si and OH expressed as a molar number. For example, when two OH groups are bound to 1 mol of each Si atom, the [number of moles of Si-OH bond] is 2 mol. The number of moles of the Si-O bond is also counted in the same manner.

The method for obtaining the silane compound is not particularly limited, but examples include the following production methods (a) and (b).
(a) Production method including a step of imidating an intermediate (made of silane compound) represented by average composition formula X'aYbZcSiOd having a siloxane bond and an organic backbone X' having an amide bond, corresponding to the organic backbone including an imide bond X in the silane compound.
(b) Production method including a step of hydrolyzing and condensing an intermediate made of a silane compound in which an organic backbone having an imide bond, corresponding to the organic backbone including an imide bond X in the silane compound, is bound to a silicon atom, and which has a hydrolyzable group.

With respect to the molecular weight of the silane compound, for example, the number average molecular weight is preferably 100 to 10000. If the silane compound is a macromolecular compound having a number average molecular weight of more than 10000, it cannot be more sufficiently mixed with the aromatic amine compound in some cases. If the number average molecular weight is less than 100, resistance to thermal decomposition and the like cannot be sufficient in some cases. The number average molecular weight is more preferably 100 to 800 and further preferably 100 to 600. In addition, the weight average molecular weight is preferably 100 to 10000. More preferably 100 to 800, and further preferably 100 to 600.

The molecular weights of the silane compound (number average molecular weight and weight average molecular weight) can be determined by, for example, GPC (gel permeation chromatography) measurement under measurement conditions described later.

The content of the silane compound in the silane-containing composition is preferably 10 to 200 parts by weight per 100 parts by weight of the total amount of the aromatic amine compound. If the content of the silane compound is less than 10 parts by weight, the melting point of the aromatic amine compound cannot sufficiently disappear and the softening point of the silane-containing composition cannot be sufficiently reduced, in some cases. In addition, if the content of the silane compound is more than 200 parts by weight, the silane compound cannot be more sufficiently dispersed in the aromatic amine compound, the crosslinking structure of the cured product cannot be more sufficiently uniform, and the heat resistance thereof cannot be made higher, in some cases. The content is more preferably 20 to 180 parts by weight and further preferably 50 to 150 parts by weight.

### <Silicone Rubber and/or Silicone Oil>

The silane-containing composition of the present invention may also include a silicone rubber and/or a silicone oil. That is, it preferably includes at least one selected from a group consisting of a silicone rubber and a silicone oil. When the silane-containing composition of the present invention includes a silicone rubber and/or a silicone oil, the above-mentioned silane compound is particularly preferably a form where X in the average composition formula (1) is the group represented by the formula (3) and a is a number of less than 3 but not 0. When a silicone rubber and/or a silicone oil is added to the silane compound having such a structure, a composition can be obtained in which the brittleness of the silane compound is sufficiently eliminated and which is better in heat resistance and dimension stability and also better in moldability (also referred to as shapability). Therefore, the increase in internal stress along with expansion and contraction due to change in temperature is further suppressed, and a molded product in which chipping, cracking, and the like are further suppressed can be obtained. Accordingly, the silane-containing composition and the curable resin composition including the same, according to the present invention, can be allowed to be more preferable for applications in which high moldability is demanded, such as a mechanical part application, electric and electronic component applications, and an automobile part material.

Thus, an embodiment, in which the silane-containing composition further includes a silicone rubber and/or a silicone oil, X in the average composition formula (1) denotes the group represented by the formula (3), and a is a number of less than 3 but not 0, is also one preferable embodiment of the present invention.

When the silane-containing composition further includes a silicone rubber and/or a silicone oil, such a silane-containing composition is preferably used with an epoxy resin. That is, a curable resin composition including a silicone rubber and/or a silicone oil, the silane compound, and an epoxy resin is also one preferable embodiment of the present invention. Since a cured product obtained from such a curable resin composition is low in elastic modulus, the curable resin composition can be used as a sealing material to thereby provide a coating film in which the warpage of the substrate is more effectively suppressed after curing. In addition, such a curable resin composition can include the silane compound and the aromatic ring amine compound to thereby be in particular excellent in heat resistance and sufficiently respond to the requirement of the increase in heat resistance of a sealing material in recent years. Furthermore, when the curable resin composition further includes a compound having an imide group as described later, it can have a higher heat resistance due to the formation of the crosslinking structure, and thus can be more preferably used in a sealing material application also in this regard.

As the silicone rubber, dimethylsiloxane or a solid polymer of dimethylsiloxane having a substituent such as a phenyl group, an epoxy group, a methoxy group, a silanol group or a mercapto group can be used, and also a silicone rubber powder whose surface is covered with a silicone resin (for example, product name "MKP600" produced by Shin-Etsu Chemical Co., Ltd.) or the like can be used.

The silicone rubber is preferably one having an average particle size of 0.5 to 50 µm. The silicone rubber having such an average particle size allows the resin composition to be excellent in fluidity and ease in handling.

The average particle size of the silicone rubber can be measured by particle size distribution measurement by a laser light diffraction method.

As the silicone oil, a dimethylsilicone oil, a methylphenylsilicone oil, or a silicone oil having an epoxy group, a carboxyl group, a polyether group, or the like in a side chain of a dimethylsilicone oil or a methylphenylsilicone oil can be used.

The content of the silicone rubber and/or the silicone oil in the silane-containing composition, which is the total amount of the silicone rubber and the silicone oil, is preferably 10 to 250 parts by weight per 100 parts by weight of the silane compound. Such a mixing proportion can allow the effect by mixing of the silicone rubber and/or the silicone oil to be more effectively exerted and allow the silane-containing composition and the curable resin composition including the same, according to the present invention, to be better in moldability (formability). The content is more preferably 30 to 200 parts by weight and further preferably 50 to 150 parts by weight.

When the silane-containing composition including the silicone rubber and/or the silicone oil is used with an epoxy resin and a phenol resin, the mixing proportion of the silicone rubber and/or the silicone oil, which is the total amount of the silicone rubber and the silicone oil, is preferably 2 to 50 parts by weight per 100 parts by weight of the total amount of the silane compound, the epoxy resin and the phenol resin.

### [Method of Producing Silane-Containing Composition]

In order to obtain the silane-containing composition of the present invention, for example, a step of dissolving the aromatic amine compound in a silane compound solution including the silane compound and a solvent, and then removing the solvent is preferably performed. Thus, the silane compound can be uniformly dispersed in the aromatic amine compound to suitably provide a silane-containing composition in which the silane compound and the aromatic amine compound are integrated, sufficiently exerting the effect due to the silane-containing composition. Such a method for producing the silane-containing composition, including a step of dissolving the aromatic amine compound in a silane compound solution including the silane compound and a solvent, and then removing the solvent, is also one aspect of the present invention. When the silane-containing composition further includes the silicone rubber and/or the silicone oil, a step of mixing a solid obtained in the solvent-removing step (also referred to as a desolventizing step) and the silicone rubber and/or the silicone oil is preferably performed after the desolventizing step.

When the silane-containing composition is used in an application in which a volatile component may be included, it may not undergo the desolventizing step.

The solvent (organic solvent) constituting the silane compound solution in the production method is not particularly limited as long as it can dissolve or disperse the silane compound, but is preferably, for example, a solvent containing a compound having at least one structure selected from the group consisting of an ether bond, an ester bond and a nitrogen atom.

Preferable examples of the compound having an ether bond include diethyl ether, dipropyl ether, diisopropyl ether, dibutyl ether, dihexyl ether, ethyl vinyl ether, butyl vinyl ether, anisole, phenetole, butyl phenyl ether, pentyl phenyl ether, methoxytoluene, benzyl ethyl ether, diphenyl ether, dibenzyl ether, veratrole, propylene oxide, 1,2-epoxybutane, dioxane, trioxane, furan, 2-methylfuran, tetrahydrofuran, tetrahydropyran, cineole, 1,2-dimethoxyethane, 1,2-diethoxyethane, 1,2-dibutoxyethane, glycerin ether, crown ether, methylal, acetal, methyl cellosolve, ethyl cellosolve, butyl cellosolve, ethylene glycol monopropyl ether, ethylene glycol monohexyl ether, ethylene glycol dimethyl ether, diethylene glycol, diethylene glycol methyl ether, diethylene glycol ethyl ether, diethylene glycol butyl ether, diethylene glycol dimethyl ether, diethylene glycol diethyl ether, diethylene glycol dibutyl ether, triethylene glycol, triethylene glycol monomethyl ether, tetraethylene glycol, 1-methoxy-2-propanol, 1-ethoxy-2-propanol, propylene glycol methyl ether, propylene glycol dimethyl ether, propylene glycol propyl ether, propylene glycol butyl ether, dipropylene glycol, dipropylene glycol monomethyl ether, dipropylene glycol monoethyl ether, dipropylene glycol dimethyl ether, dipropylene glycol diethyl ether, dipropylene glycol dibutyl ether, tripropylene glycol, tripropylene glycol monomethyl ether, 2-methoxyethanol, 2-ethoxyethanol, 2-(methoxymethoxy)ethanol, 2-isopropoxyethanol, 2-butoxyethanol, 2-(isopentyloxy)ethanol, 2-(hexyloxy)ethanol, 2-phenoxyethanol, 2-(benzyloxy)ethanol, furfuryl alcohol, and tetrahydrofurfuryl alcohol.

Preferable examples of the compound having an ester bond include methyl formate, ethyl formate, propyl formate, butyl formate, isobutyl formate, pentyl formate, methyl acetate, ethyl acetate, propyl acetate, isopropyl acetate, butyl acetate, isobutyl acetate, sec-butyl acetate, pentyl acetate, isopentyl acetate, 3-methoxybutyl acetate, sec-hexyl acetate, 2-ethylbutyl acetate, 2-ethylhexyl acetate, cyclohexyl acetate, benzyl acetate, methyl propionate, ethyl propionate, butyl propionate, isopentyl propionate, ethylene glycol monoacetate, diethylene glycol monoacetate, monoacetin, diacetin, triacetin, monobutyrine, dimethyl carbonate, diethyl carbonate, dipropyl carbonate, dibutyl carbonate, butyrates, isobutyrates, isovalerates, stearates, benzoates, ethyl cinnamates, abietates, adipates, γ-butyrolactones, oxalates, malonates, maleates, tartrates, citrates, sebacates, phthalates, and ethylene diacetates.

Preferable examples of the compound having a nitrogen atom include nitromethane, nitroethane, 1-nitropropane, 2-nitropropane, nitrobenzene, acetonitrile, propionitrile, succinonitrile, butyronitrile, isobutyronitrile, valeronitrile, benzonitrile, α-tolunitrile, formamide, N-methylformamide, N,N-dimethylformamide, N,N-diethylformamide, acetamide, N-methylacetamide, N,N-dimethylacetamide, N,N-diethylacetamide, 2-pyrrolidone, N-methylpyrrolidone, and ε-caprolactam.

Preferable examples of the compound having a plurality of structures selected from the group consisting of an ether bond, an ester bond and a nitrogen atom include N-ethylmorpholine, N-phenylmorpholine, methyl cellosolve acetate, ethyl cellosolve acetate, propyl cellosolve acetate, butyl cellosolve acetate, phenoxyethyl acetate, diethylene glycol monomethyl ether acetate, diethylene glycolmonoethyl ether acetate, diethylene glycol monopropyl ether acetate, diethylene glycol monobutyl ether acetate, propylene glycol methyl ether acetate, propylene glycol ethyl ether acetate, propylene glycol propyl ether acetate, propylene glycol butyl ether acetate, dipropylene glycol methyl ether acetate, dipropylene glycol ethyl ether acetate, dipropylene glycol propyl ether acetate, dipropylene glycol butyl ether acetate, and tripropylene glycol methyl ether acetate. These compounds can be used singly or in combination of two or more.

The amount of the solvent used is preferably 5 to 70% by mass per 100% by mass of the total amount of the silane compound and the solvent. The amount is more preferably 10 to 60% by mass and further preferably 10 to 50% by mass.

The method for dissolving the aromatic amine compound in the silane compound solution and the method for removing the solvent in the above production method are not particularly limited, and usual procedures may be performed therefor. The above production method may also include other step if necessary.

Since the silane-containing composition of the present invention has the above configuration, the composition has such a specific property that while the composition has excellent characteristics of the aromatic amine compound and the silane compound, the melting point of the aromatic amine compound disappears and the composition can be softened at a temperature of 100°C or lower. Accordingly, for example, when the silane-containing composition is used as a curing agent of an epoxy group-containing compound, an inorganic filling material is further mixed therewith, and a composition including at least such three components is melt mixed, the composition not only can be easily molten and mixed with having good handleability while a crosslinking (curing) reaction of the epoxy group-containing compound does not progress at the melting temperatures of the silane-containing composition and the epoxy group-containing compound, but also can provide a cured product extremely high in mechanical strength and glass transition temperature due to the aromatic amine compound. Therefore, the silane-containing composition of the present invention can be used to preferably provide a high-performance sealing material that is extremely useful in electric and electronic component applications. That is, the silane-containing composition is preferably a sealing material composition, and such an embodiment is one preferable embodiment of the present invention.

### [Curable Resin Composition]

The present invention also provides a curable resin composition including the silane-containing composition of the present invention, an epoxy resin and an inorganic filling material. Each of the components contained in such a curable resin composition can be used singly or in combination of two or more. As long as the curable resin composition essentially includes these components, it can also appropriately include other components. Other components are as described later.

### <Epoxy Resin>

In the curable resin composition, the epoxy resin (also referred to as epoxy group-containing compound) is not particularly limited as long as it is a compound including one or more epoxy groups in the molecule, and examples thereof include the following compounds: an epi-bis type glycidyl ether epoxy resin obtained by condensation reaction of bisphenols (bisphenol A, bisphenol F, bisphenol S, and the like) with epihalohydrin; a high molecular weight epi-bis type glycidyl ether epoxy resin obtained by further addition reaction of the above epoxy resin with bisphenols (bisphenol A, bisphenol F, bisphenol S, and the like); a novolac-aralkyl type glycidyl ether epoxy resin obtained by subjecting phenols (phenol, cresol, xylenol, naphthol, resorcin, catechol, bisphenol A, bisphenol F, bisphenol S, and the like) and formaldehyde, acetaldehyde, propionaldehyde, benzaldehyde, hydroxybenzaldehyde, salicylaldehyde, dicyclopentadiene, terpene, coumarin, p-xylene glycol dimethyl ether, dichloro-p-xylylene, bis(hydroxymethyl)biphenyl, or the like to condensation reaction to provide polyhydric phenols, and further subjecting the polyhydric phenols to condensation reaction with epihalohydrin; an aromatic crystalline epoxy resin obtained by condensation reaction of tetramethylbiphenol, tetramethylbisphenol F, hydroquinone, naphthalenediol, or the like with epihalohydrin; a polymer of an aromatic crystalline epoxy resin obtained by further addition reaction of the bisphenols, tetramethylbiphenol, tetramethylbisphenol F, hydroquinone, naphthalenediol, or the like to the aromatic crystalline epoxy resin; a trisphenol epoxy resin;
an aliphatic glycidyl ether epoxy resin obtained by condensation reaction of the bisphenols, alicyclic glycols in which an aromatic ring backbone is hydrogenated (tetramethylbiphenol, tetramethylbisphenol F, hydroquinone, naphthalenediol, or the like), or mono/polysaccharides (ethylene glycol, diethylene glycol, triethylene glycol, tetraethylene glycol, PEG600, propylene glycol, dipropylene glycol, tripropylene glycol, tetrapropylene glycol, polypropylene glycol, PPG, glycerol, diglycerol, tetraglycerol, polyglycerol, trimethylolpropane and a multimer thereof, pentaerythritol and a multimer thereof, glucose, fructose, lactose, maltose, or the like) with epihalohydrin; a high molecular weight aliphatic glycidyl ether epoxy resin obtained by further addition reaction of the aliphatic glycidyl ether epoxy resin with the bisphenols; an epoxy resin having an epoxycyclohexane backbone, such as (3,4-epoxycyclohexane)methyl 3',4'-epoxycyclohexyl carboxylate; a glycidyl ester epoxy resin obtained by condensation reaction of tetrahydrophthalic acid, hexahydrophthalic acid, benzoic acid, or the like with epihalohydrin; and a tertiary amine-containing glycidyl ether epoxy resin that is solid at room temperature, obtained by condensation reaction of hydantoin, cyanuric acid, melamine, benzoguanamine, or the like with epihalohydrin; and the like.

Among these epoxy group-containing compounds, an aliphatic glycidyl ether epoxy resin is preferable. In order to further increase curing ability, a compound having two or more epoxy groups in the molecule (polyfunctional epoxy compound) is preferably used.

In the present specification, a glycidyl group is encompassed in an epoxy group.

The epoxy group-containing compound preferably has a weight average molecular weight of 200 to 20000. An epoxy group-containing compound having such a molecular weight can be used to thereby provide a cured product further sufficiently cured. The weight average molecular weight is more preferably 220 to 18000 and further preferably 250 to 15000.

The weight average molecular weight of the epoxy group-containing compound can be determined by, for example, GPC (gel permeation chromatography) measurement under measurement conditions described later.

The proportion of the epoxy group-containing compound contained in the curable resin composition is preferably 10 to 500 parts by weight per 100 parts by weight of the total amount of the silane compound and the aromatic amine compound constituting the silane-containing composition. The content rate can be set within the range to thereby allow the silane-containing composition to more effectively act as a curing agent of the epoxy group-containing compound. The content rate is more preferably 20 to 200 parts by weight and further preferably 50 to 150 parts by weight.

The epoxy equivalent in the curable resin composition is preferably 100 to 450 g/mol. More preferably is 120 to 420 g/mol, and further preferably 150 to 400 g/mol.

### <Phenol Resin>

The curable resin composition may also further include a phenol resin. The curable resin can further include a phenol resin to allow the phenol resin to act as a curing agent of the resin component such as the epoxy resin, thereby further enhancing curing speed and allowing a cured product obtained to be better in flexibility and mechanical strength. Such an embodiment in which the curable resin composition further includes a phenol resin is also one preferable embodiment of the present invention.

The phenol resin is not particularly limited as long as it is a compound including an aromatic ring having at least one phenolic hydroxyl group, and for example, the following compounds can be used singly or in combination of two or more:
various phenol resins such as a phenol novolac resin, a cresol novolac resin, a bisphenol A novolac resin, a dicyclopentadiene phenol resin, a phenol aralkyl resin and a terpene phenol resin; and
polyhydric phenol resins obtained by condensation reaction of various phenols with various aldehydes such as hydroxybenzaldehyde, crotonaldehyde and glyoxal.

Among the phenol resins, a compound having a structure in which aromatic ring backbones having at least one phenolic hydroxyl group are bound to each other via an organic backbone having 2 or more carbon atoms (the compound is also referred to as "polyphenolic compound" below) is preferable.

The aromatic ring backbone having at least one phenolic hydroxyl group in the polyphenolic compound is an aromatic ring having at least one phenolic hydroxyl group. For example, a moiety having a structure such as phenol, hydroquinone, naphthol, anthracenol, bisphenol or biphenol structure is preferable. Among them, a phenol structure is preferable. The moiety having such a phenol structure may also be appropriately substituted with an alkyl group, an alkylene group, an aralkyl group, a phenyl group, a phenylene group, or the like.

The organic backbone in the polyphenolic compound means a moiety bonding aromatic ring backbones constituting the polyphenolic compound to each other and which essentially has a carbon atom. The organic backbone having 2 or more carbon atoms preferably have a ring structure. The ring structure is a structure having a ring such as an aliphatic ring or an aromatic ring, and such a ring is preferably a cyclopentane ring, cyclohexane ring, benzene ring, naphthalene ring, anthracene ring, or the like.

The organic backbone preferably have a ring structure containing a nitrogen atom, such as a triazine ring and a phosphazene ring, and/or an aromatic ring, and particularly preferably have a triazine ring and/or an aromatic ring among them.

Herein, the polyphenolic compound may have an aromatic ring backbone and an organic backbone other than the above, and may simultaneously have a structure in which aromatic ring backbones having at least one phenolic hydroxyl group are bound to each other via an organic backbone (methylene) having one carbon atom.

The phenol resin preferably has a weight average molecular weight of 100 to 1600. A phenol resin having such a molecular weight can be used to thereby provide a cured product more sufficiently cured. The weight average molecular weight is more preferably 200 to 1500 and further preferably 300 to 1400.

The weight average molecular weight of the phenol resin can be determined by, for example, GPC (gel permeation chromatography) measurement under measurement conditions described later.

The proportion of the phenol resin contained in the curable resin composition is preferably 10 to 100 parts by weight per 100 parts by weight of the epoxy resin in the curable resin composition. The content rate is more preferably 15 to 80 parts by weight and further preferably 20 to 60 parts by weight.

The mixing ratio of the aromatic amine compound to the phenol resin contained in the silane-containing composition (aromatic amine compound/phenol resin) is preferably 80/20 to 20/80 in the functional group equivalent (molar equivalent) ratio of both the compounds. When the aromatic amine compound and the phenol resin acting as the curing agents are contained in such a ratio, the cured product obtained from the curable resin composition of the present invention exerts all characteristics including high heat resistance and flexibility, and mechanical strength in a well-balanced manner. The mass ratio of the aromatic amine compound and the phenol resin is more preferably 70/30 to 30/70 and further preferably 60/40 to 40/60.

### <Inorganic Filling Material>

In the curable resin composition, the inorganic filling material (also referred to as an inorganic filling agent) is not particularly limited, and one for use in a sealing material of a usual mounting substrate may be used. In particular, silica and a composite metal hydroxide are preferable. More preferably, at least silica is used. Such an embodiment in which the inorganic filling material includes silica is also one preferable embodiment of the present invention. In addition, an embodiment in which the inorganic filling material includes silica and a composite metal hydroxide is also one preferable embodiment of the present invention.

### -Silica-

Examples of the silica include molten silica (fused silica) and crystal silica. Among them, molten silica is preferable from the viewpoint of fluidity.

The average particle size of the silica is preferably 5 to 50 µm. More preferably is 7 to 45 µm, and further preferably 10 to 40 µm.

The average particle size can be measured by particle size distribution measurement by a laser light diffraction method.

The silica preferably has a degree of circularity of 0.85 to 0.98. Thus, the curable resin composition can be excellent in fluidity. The degree of circularity is more preferably 0.88 to 0.98 and further preferably 0.9 to 0.98.

Herein, the degree of circularity is expressed as a ratio of the circumference of a circle having the same area as that of the projection image of a particle to the length of the periphery of the projection image of the particle, and can be measured using a particle image analyzing apparatus or the like.

### -Composite Metal Hydroxide-

The inorganic filling material may also include a composite metal hydroxide. In particular, silica and a composite metal hydroxide are preferably used at the same time. Thus, the curable resin composition can be excellent in all of fluidity, heat resistance and flame retardance. Such an embodiment in which the inorganic filling material includes silica and a composite metal hydroxide is one preferable embodiment of the present invention. Herein, such a curable resin composition is preferable in particular for a sealing material application. That is, an embodiment in which the curable resin composition is a sealing material resin composition is also one preferable embodiment of the present invention.

Preferable examples of the composite metal hydroxide include one represented by the following general formula (I).

m(MₐO_{b})·n(Q_{d}Oₑ)·cH₂O (I)

In the formula (I), M and Q denote a different metal element from each other, M represents at least one metal element selected from the group consisting of Al, Mg, Ca, Ni, Co, Sn, Zn, Cu, Fe and Ti, and Q represents at least one metal element selected from the group consisting of metal elements belonging to Group 4 to Group 12 on the periodic table. m, n, a, b, c, d and e are each a positive number and may be the same value or a different value from one another. When a plurality of M(s) are present, each M may be the same or different, and when a plurality of Q(s) are present, each Q may be the same or different.

M denoting a metal element in the general formula (I) includes at least one metal element selected from the group consisting of Al, Mg, Ca, Ni, Co, Sn, Zn, Cu, Fe and Ti, and preferably denotes Al, Mg, or Zn. These can be used singly or in combination of two or more. In addition, Q denoting another metal element in the general formula (I) denotes at least one metal element selected from the group consisting of metal elements belonging to Group 4 to Group 12 on the periodic table. Examples thereof preferably include Fe, Co, Ni, Pd, Cu, and Zn. These can be used singly or in combination of two or more.

Herein, although some metal elements are exemplified in both of M and Q, the metal elements denoted by M and Q may be selected so that they are different from each other.

With respect to the composite metal hydroxides, a combination of Mg and Zn or the like is preferable as a combination of M and Q, from the viewpoint of flame retardance.

The average particle size of the composite metal hydroxide is preferably 0.3 to 2 µm. When the silica having a preferable average particle size described above as the inorganic filling material is used, one having an average particle size in such a range is used as the composite metal hydroxide to easily result in slipping of particles due to the difference in particle size between the silica and the composite metal hydroxide, further enhancing the fluidity of the curable resin composition. The average particle size of the composite metal hydroxide is more preferably 0.5 to 1.8 µm and further preferably 0.7 to 1.5 µm.

The average particle size can be measured by particle size distribution measurement by a laser light diffraction method.

The shape of the composite metal hydroxide is not particularly limited, but is preferably a polyhedron shape or the like from the viewpoint that the composite metal hydroxide is used with the inorganic filling material to thereby make the fluidity enhancement effect better.

The polyhedron shape may be a shape that is not planar, examples thereof preferably include a substantial tetrahedron shape, a substantial octahedron shape, a substantial dodecahedron shape and a substantial hexadecahedron shape, and a shape closer to sphere is more preferable.

The method for producing the composite metal hydroxide is not particularly limited, and for example, when M represents Mg and Q represents Zn, the following method is adopted.

First, a zinc nitride compound is added to an aqueous magnesium hydroxide solution to prepare a partially combined metal hydroxide serving as a raw material. Then, this raw material is burned in a range from about 800 to 1500°C to thereby prepare a combined metal oxide. This combined metal oxide, denoted by m(MgO)·n(ZnO), can be subjected to hydration reaction at a temperature of 40°C or higher while being strongly stirred in a water medium system in which acetic acid coexists therewith in an amount of about 0.1 to 6 mol% based on the combined metal oxide, thereby preparing a combined metal hydroxide represented by m (MgO)·n (ZnO)·cH₂O

The proportion of the inorganic filling material contained in the curable resin composition is preferably 50 to 95% by mass per 100% by mass of the whole amount of the curable resin composition. The content rate is more preferably 60 to 93% by mass and further preferably 70 to 90% by mass. The inorganic filling material can be used in such a large amount to thereby sufficiently prevent the warpage of a mounting substrate from being generated after curing when the curable resin composition of the present invention is used for providing the sealing material of the mounting substrate and the like.

Herein, the curable resin composition of the present invention, even if having the inorganic filling material in a large amount, can be easily prepared with having good handleability and can sufficiently exert performances of the aromatic amine compound and the epoxy group-containing compound.

When the silica and the composite metal hydroxide are used as the inorganic filling material at the same time as described above, the content of the silica is particularly preferably 40 to 95% by mass per 100% by mass of the whole amount of the curable resin composition from the viewpoint of reducing linear expansion coefficient. The content is more preferably 50 to 92% by mass and further preferably 60 to 90% by mass. The silica can be used in such a large amount to thereby sufficiently prevent the warpage of a mounting substrate from being generated after curing when the curable resin composition of the present invention is used for providing the sealing material of the mounting substrate or the like. In addition, the content of the composite metal hydroxide here is preferably 3 to 50 parts by weight per 100 parts by weight of the silica. Thus, the composite metal hydroxide can be used with the silica to thereby further exhibit the fluidity enhancement effect. The content is more preferably 3.5 to 45 parts by weight and further preferably 4 to 40 parts by weight.

Herein, the curable resin composition of the present invention, even if containing the silica in a large amount, can be used with the composite metal hydroxide to result in further enhancement fluidity and to be more easily prepared.

### <Compound Having Imide Group>

The curable resin composition may also further include a compound having an imide group (also referred to as an "imide compound" or an "imide component"). When the silane compound included in the silane-containing composition is the compound having a polymerizable unsaturated carbon bond in the molecule, as described above, the compound having an imide group can be further included to allow the silane compound to form a crosslinking structure, thereby allowing the cured product obtained from the curable resin composition of the present invention to be higher in heat resistance. Such an embodiment in which the curable resin composition further includes the compound having an imide group is also one preferable embodiment of the present invention.

The compound having an imide group is preferably a maleimide compound.

The maleimide compound is preferably a bismaleimide compound having two or more maleimide groups in the molecule (also referred to as a "bismaleimide resin"), and for example, a co-condensate of a bismaleimide and an aldehyde compound can be used singly or in combination of two or more.

Examples of the bismaleimide include 4,4'-diphenylmethanebismaleimide, N,N'-ethylenebismaleimide, N,N'-hexamethylenebismaleimide, N,N'-m-phenylenebismaleimide, N,N'-p-phenylenebismaleimide, 2,2-bis[4-(4-maleimidophenoxy)phenyl]propane, bis[4-(4-maleimidophenoxy)phenyl]methane, 1,1,1,3,3,3-hexafluoro-2,2-bis[4-(4-maleimidophenoxy)phenyl]propane, N,N'-p,p'-diphenyldimethylsilylbismaleimide, N,N'-4,4'-diphenyl etherbismaleimide, N,N'-methylenebis(3-chloro-p-phenylene)bismaleimide, N,N'-4,4'-diphenylsulfonebismaleimide, N,N'-4,4'-dicyclohexylmethanebismaleimide, N,N'-dimethylenecyclohexanebismaleimide, N,N'-m-xylenebismaleimide, N,N'-4,4'-diphenylcyclohexanebismaleimide, and N-phenylmaleimide.

Examples of the aldehyde compound include formaldehyde, acetaldehyde, benzaldehyde, and hydroxyphenylaldehyde.

The bismaleimide resin may also be a compound represented by the following general formula (4).

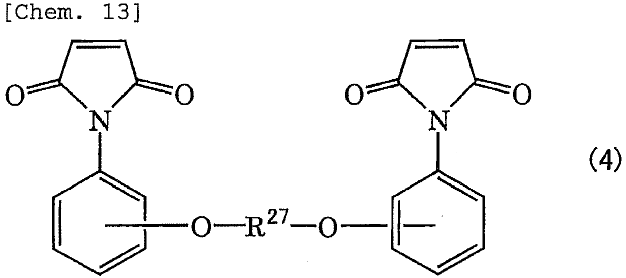

wherein R²⁷ represents a divalent group represented by the following formula:

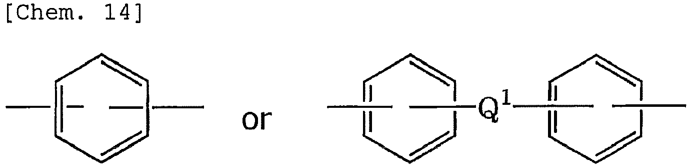

Q¹ denotes a group directly connecting to two aromatic rings, and represents at least one group selected from the group consisting of a divalent hydrocarbon group having 1 to 10 carbon atoms, a hexafluoroisopropylidene group, a carbonyl group, a thio group, a sulfinyl group, a sulfonyl group and an oxide group.

Specifically, preferable examples of the bismaleimide resin represented by the general formula (4) include 1,3-bis(3-maleimidophenoxy)benzene, bis[4-(3-maleimidophenoxy)phenyl]methane, 1,1-bis[4-(3-maleimidophenoxy)phenyl]ethane, 1,2-[4-(3-maleimidophenoxy)phenyl]ethane, 2,2-bis[4-(3-maleimidophenoxy)phenyl]propane, 2,2-bis[4-(3-maleimidophenoxy)phenyl]butane, 2,2-bis[4-(3-maleimidophenoxy)phenyl]-1,1,1,3,3,3-hexafluoropropane, 4,4-bis(3-maleimidophenoxy)biphenyl, bis[4-(3-maleimidophenoxy)phenyl]ketone, bis[4-(3-maleimidophenoxy)phenyl]sulfide, bis[4-(3-maleimidophenoxy)phenyl]sulfoxide, bis[4-(3-maleimidophenoxy)phenyl]sulfone, bis[4-(3-maleimidophenoxy)phenyl]ether, and a compound represented by the following general formula (5): 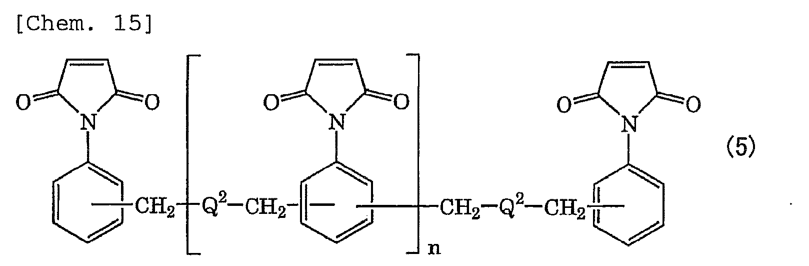 wherein Q² represents a divalent group made of an aromatic ring optionally having a substituent. n represents the number of repetitions and is a number of 0 to 10 in average.

Specifically, Q² preferably includes divalent groups such as a phenyl group, a biphenyl group and a naphthyl group (a phenylene group, a biphenylene group, a naphthyridine group, and the like).

When the curable resin composition includes the compound having an imide group, the mixing ratio of the silane compound to the compound having an imide group (silane compound/compound having an imide group) is preferably 10/90 to 90/10 in the unsaturated bond equivalent (molar equivalent) ratio of both the compounds. The blending ratio is more preferably 15/85 to 85/15 and further preferably 20/80 to 80/20.

### <Other Components>

The curable resin composition may also contain additives (also referred to as "other components") other than the silane-containing composition, the epoxy group-containing compound and the inorganic filling material as described above. Examples include a volatile component such as an organic solvent or a diluent, a curing agent other than the aromatic amine compound and the phenol resin as described above, a curing accelerator, a stabilizer, a release agent, a coupling agent, a colorant, a plasticizer, a flexibilizer, various rubber materials, a photosensitizer, a flame retardant, and a pigment, and these can be used singly or in combination of two or more.

The volatile component is not particularly limited, and one usually used may be used.

While the curable resin composition of the present invention can be used in an application in which no volatile component is desirably included as much as possible, namely, for example, a mounting application, an optical application, an optical device application, a mechanical part application, electric and electronic component applications, an automobile part application and the like, the content of the volatile component in 100% by mass of the curable resin composition here is preferably 10% by mass or less. The content is more preferably 5% by mass or less and further preferably 3% by mass or less, and particularly preferably no volatile component is substantially included. No volatile component being substantially included means that the content of the volatile component is less than an amount that can allow the composition to be dissolved, and for example, such an amount is preferably 1% by mass or less in 100% by mass of the curable resin composition. When the curable resin composition is used in an application in which the volatile component may be included, such as a printing ink application, the curable resin composition may include the volatile component, and such an embodiment is also one preferable embodiment of the present invention.

Examples of the curing agent other than the aromatic amine compound and the phenol resin as described above include acid anhydrides such as methyltetrahydrophthalic anhydride, hexahydrophthalic anhydride, methylhexahydrophthalic anhydride, pyromellitic anhydride and methylnadic anhydride; various phenol resins such as a phenol novolac resin, a cresol novolac resin, a bisphenol A novolac resin, a dicyclopentadiene phenol resin, a phenol aralkyl resin and a terpenephenol resin; polyhydric phenol resins obtained by condensation reaction of various phenols with various aldehydes such as hydroxybenzaldehyde, crotonaldehyde and glyoxal; a BF₃ complex; sulfonium salts; and imidazoles;.

The curing accelerator is preferably, for example, one, or two or more of organophosphorus compounds such as triphenylphosphine, tributylhexadecylphosphonium bromide, tributylphosphine and tris(dimethoxyphenyl)phosphine.

The proportion of other components contained in the curable resin composition, as the total amount thereof, is preferably 20% by mass or less per 100% by mass of the whole amount of the curable resin composition. The content rate is more preferably 15% by mass or less and further preferably 10% by mass or less.

The method for producing the curable resin composition is not particularly limited. For example, the curable resin composition can be produced by obtaining the silane-containing composition by the above-mentioned method for producing the silane-containing composition, and then adding thereto the epoxy group-containing compound, the inorganic filling material and if necessary other components and mixing them. Since the curable resin composition of the present invention can be easily prepared with having good handleability due to the specific property of the silane-containing composition (namely, the property that the melting point of the aromatic amine compound disappears and the composition can be softened at a temperature of 100°C or lower), the mixing step of the silane-containing composition, the epoxy group-containing compound, the inorganic filling material and if necessary other components can be easily performed without requiring a special machine. Accordingly, when the curable resin composition is solid, any mixer usually used in heat-mixing, such as a kneader, a roll, a single-screw kneading extruder or a twin-screw kneading extruder can be used to suitably perform the mixing step. In addition, when the curable resin composition is liquid, any mixer usually used, such as a kneader, a roll, a single-screw kneading extruder, a twin-screw kneading extruder or a planetary mixer can be used to suitably perform the mixing step.

The curable resin composition preferably has a viscosity at 150°C of 0.01 to 60 Pa·s. When the curable resin composition has such an appropriate viscosity, it is excellent in handleability during coating, for example. The viscosity is more preferably 0.02 to 40 Pa·s.

The viscosity can be measured at 150 ± 1°C using, for example, an E type viscometer (manufactured by Brookfield Engineering).

When the curable resin composition is solid at ordinary temperature (23°C), it preferably has a viscosity at 175°C of 1 to 100 Pa·s. When the curable resin composition has such an appropriate viscosity, it is better in fluidity and better in shapability during transfer mold shaping (transfer molding). The viscosity is more preferably 10 to 70 Pa·s.

The viscosity of the solid sealing material resin composition can be measured at 175°C using a flow tester.

When the curable resin composition is liquid at ordinary temperature (23°C), it preferably has a viscosity at 25°C of 0.1 to 200 Pa·s. When the curable resin composition has such an appropriate viscosity, it is better in fluidity and better in filling ability during sealing by potting and the like. The viscosity is more preferably 1 to 100 Pa·s.

The viscosity of the liquid sealing material resin composition can be measured at 25°C using an E type viscometer.

When the curable resin composition is liquid at ordinary temperature (23°C), it preferably has a viscosity at 60°C of 0.5 to 60 Pa·s. When the curable resin composition has such an appropriate viscosity, it is better in fluidity and better in filling ability during sealing by potting. The viscosity is more preferably 1 to 50 Pa·s.

The viscosity of the liquid sealing material resin composition can be measured at 60°C using a dynamic viscoelasticity measuring apparatus.

The lower limit of the heat softening temperature of the curable resin composition is preferably 45°C. The lower limit is more preferably 70°C. In addition, the upper limit is preferably 200°C. The upper limit is more preferably 150°C. With respect to the melting point, the lower limit is preferably 80°C. More preferably is 100°C.

In addition, the upper limit is preferably 300°C. More preferably is 250°C.

### [Cured Product]

The curable resin composition of the present invention can be, for example, heat-cured to thereby provide a cured product. The curing method is not particularly limited, and a usual heat-curing procedure may be adopted. For example, the heat-curing temperature is preferably 70 to 250°C, more preferably 70 to 200°C, and further preferably 80 to 200°C. In addition, the curing time is preferably 1 to 15 hours, more preferably 2 to 10 hours, and further preferably 5 to 10 hours.

Examples of the shape of the cured product include a molded article of a profile or the like, and a film, a sheet and a pellet. Such a cured product formed by using the curable resin composition of the present invention (cured product formed from the curable resin composition of the present invention) is also one preferable embodiment of the present invention.

The cured product preferably has a glass transition temperature by a thermomechanical analysis apparatus (TMA) of 230°C or higher. Thus, the cured product can be more suitably utilized for an electronics mounting material such as a sealing material of a mounting substrate. The glass transition temperature is more preferably 240°C or higher, further preferably 245°C or higher, and particularly preferably 250°C or higher.

Since the cured product is obtained from the curable resin composition of the present invention and thus is remarkably high in glass transition temperature and also extremely excellent in mechanical strength, it is useful in various applications such as a mounting application, an optical application, an optical device application, a display device application, a mechanical part application, electric and electronic component applications, part applications for automobiles, boats and ships, airplanes, and the like, a civil engineering and construction material application, a molding material application, a printing ink application, and material applications for paints, adhesives, and the like. Specifically, the cured product can be suitably used in, for example, an electronic component such as a printed wiring board, a build-up type wiring substrate, a solder resist, a stacked board, a light emitting diode (LED) material, a seal material for liquid crystal displays or organic electroluminescences (organic ELs) or a semiconductor device material; a civil engineering material such as a fiber-reinforced plastic (FRP); a cast molding material; or a raw material for adhesives or electric insulating paints. More specifically, the cured product is preferably used in an electronic component such as an electronics mounting material including a sealing material, a potting material, an under filling material, a conductive paste, an insulating paste or a die bonding material; a printing ink; or the like. In particular, the cured product is preferably used in an electronic component. Among electronic components, the cured product is further preferably used in an electronics mounting material, and in particular is extremely useful as a sealing material of a mounting substrate. Such a sealing material formed by using the curable resin composition is also one of the present invention. The sealing material is particularly preferably a semiconductor sealing material. A semiconductor device or a printed wiring board constructed by using the cured product is also included in preferable embodiments of the present invention.

While the sealing material is, for example, a member for use in sealing of a semiconductor component, it can include, for example, a curing accelerator, a stabilizer, a release agent, a coupling agent, a colorant, a plasticizer, a flexibilizer, various rubber materials, a photosensitizer, a filling material, a flame retardant, and a pigment as long as the effect of the present invention is not impaired. Since the sealing material, if including the volatile component in a large amount, can cause any failures, it desirably include no volatile component, and the content of the volatile component in 100% by mass of the sealing material is preferably, for example, 10% by mass or less. The content is more preferably 5% by mass or less and further preferably 3% by mass or less, and particularly preferably no volatile component is substantially included.

As the method for curing the curable resin composition (namely, the method for producing the cured product), particularly suitably the curable resin composition is cured (molded), and then a molded product thus obtained is post-cured. That is, the method preferably includes a step of molding the curable resin composition and a step of post-curing the resulting molded product. Such a method can be used to thereby provide a cured product having a higher heat resistance and also being better in mechanical strength.

The step of molding the curable resin composition (hereinafter, also referred to as a "molding step") is not particularly limited, and examples thereof include molding using a molding machine or the like. The molding machine is not particularly limited as long as it is usually used, and examples thereof include a transfer molding machine, a heating type compression molding machine and an injection molding machine.

The molding temperature is preferably set to 150 to 190°C from the viewpoint of the gelation time of the curable resin composition to be used. The molding temperature is more preferably 160 to 180°C, further preferably 170 to 180°C, and particularly preferably 175°C.

The molding time is preferably 1 to 10 minutes from the viewpoint of the mechanical strength of the resulting molded product. The molding time is more preferably 2 to 6 minutes and further preferably 3 to 6 minutes.

The shape of the molded product obtained in the molding step is not particularly limited, but examples thereof include a molded product of a profile or the like, a film, a sheet and a pellet.

The step of post-curing the molded product obtained in the molding step (hereinafter, also referred to a "post-curing step") is a step of further heating the molded product for further curing. Such a post-curing step can be performed by using, for example, an oven or a heating type pressing plate and the like and placing the molded product therein.

The curing temperature in the post-curing step (post-curing temperature) is preferably set to a temperature higher than the molding temperature (molding temperature in the molding step) by 30°C or higher. Thus, a cured product is obtained which has a higher glass transition temperature (Tg), for example, a high heat resistance of 200°C or higher, and which has a better mechanical strength. Such a method for producing the cured product of the curable resin composition, including the step of molding the curable resin composition and the step of post-curing the resulting molded product, wherein the post-curing temperature is a temperature higher than the molding temperature by 30°C or higher, is also one of the present invention. Such a production method is particularly preferable as a method for producing an electronic component such as an electronics mounting material. That is, a method for producing an electronic component by using the curable resin composition, including the step of molding the curable resin composition and the step of post-curing the resulting molded product, wherein the post-curing temperature is a temperature higher than the molding temperature by 30°C or higher is also one preferable embodiment of the present invention.

The post-curing temperature is more preferably a temperature higher than the molding temperature by 40°C or higher. The post-curing temperature is preferably a temperature higher than the molding temperature by 90°C or lower from the viewpoint of further preventing the cracking of the cured product.

Specifically, the post-curing temperature is preferably set to 200 to 250°C from the viewpoint of providing a cured product having a higher heat resistance and a better mechanical strength. The post-curing temperature is more preferably 220 to 250°C and further preferably 230 to 250°C.

The post-curing time is preferably set to 1 to 10 hours from the viewpoint of providing a cured product having a high heat resistance and an excellent mechanical strength. The post-curing time is more preferably 2 to 10 hours and further preferably 3 to 10 hours.

### - Advantageous Effects of Invention

The silane-containing composition of the present invention has the above configuration and has such a specific property that while the composition has excellent characteristics of the aromatic amine compound and the silane compound, the melting point of the aromatic amine compound disappears and the composition can be softened at a temperature of 100°C or lower. Accordingly, the silane-containing composition is used as a curing agent of the epoxy group-containing compound and the inorganic filling material is mixed therewith to thereby easily prepare a curable resin composition including such three components, and the curable resin composition can provide a cured product having extremely high mechanical strength and glass transition temperature. Therefore, the silane-containing composition of the present invention can be used to suitably provide a high-performance sealing material that is extremely useful in electric and electronic component applications.

In addition, when the silane-containing composition further includes the silicone rubber and/or the silicone oil, it can exhibit better heat resistance and moldability. A curable resin composition including such a silane-containing composition can provide a cured product that has improved brittleness and that is also excellent in moldability while having an excellent heat resistance. Such a curable resin composition is particularly effective as a low-modulus resin composition.

When the silane-containing composition is used with the epoxy resin and the phenol resin, such a composition has a higher heat resistance and is also better in flexibility and mechanical strength, and thus can be suitably used in a sealing material of a high heat resistant semiconductor. Such a curable resin composition including the silane-containing composition, the epoxy resin and the phenol resin can provide a cured product that has a high heat resistance, that is also excellent in flexibility and mechanical strength, and that is more sufficiently suppressed in terms of generation of failures such as peeling and breaking of a sealing material, the cured product being able to be suitably used as a sealing material of a high heat resistant semiconductor chip such as a SiC device, and can be more suitably used as a sealing material of an electronic component, a semiconductor chip, or the like.

### DESCRIPTION OF EMBODIMENTS

The present invention will be described in more detail below with reference to Examples, but the present invention is not to be limited only to these Examples. Unless otherwise stated, "part(s)" and "%" mean "part(s) by weight" and "% by mass", respectively.

Herein, the molecular weights of the respective components (number average molecular weight and weight average molecular weight) were determined by GPC (gel permeation chromatography) measurement under the following measurement conditions.
Measurement instrument: HLC-8120GPC (trade name, manufactured by Tosoh Corporation)
Molecular weight column: TSK-GEL GMHXL-L and TSK-GELG5000HXL (both manufactured by Tosoh Corporation) were connected in series and used.
Eluent: tetrahydrofuran (THF)
Standard substance for calibration curve: polystyrene (produced by Tosoh Corporation)
Measurement method: an object to be measured was dissolved in THF so that the solid content was about 0.2% by mass, the resultant was filtered by a filter to provide a measurement sample, and the molecular weight of the sample was measured.

### Synthesis Example 1 (silane compound solution 1)

### Synthesis of poly[(cis-4-cyclohexene-1,2-imido)propylsilsesquioxane]

A 500-mL four-necked flask equipped with a stirring apparatus, a temperature sensor and a condenser tube was charged with 103.7 g of diglyme previously dried by a molecular sieve and 177.6 g of 3-aminopropyl trimethoxysilane, and the content was heated to 100°C under a dry nitrogen flow with being stirred, to remove moisture in the system. Then, 150.7 g of cis-4-cyclohexene-1,2-dicarboxylic anhydride added therein in a tetrameric manner (also referred to as "in four portions") over 30 minutes while the reaction liquid temperature was kept at 80°C. At 3 hours after the completion of charging, it was confirmed by high-performance liquid chromatography that cis-4-cyclohexene-1,2-dicarboxylic anhydride was completely consumed.

Subsequently, 53.4 g of deionized water was added at one time, the content was heated so that the reflux of by-product methanol occurred by the condenser tube, and held for 6 hours, and thereafter the condenser tube was replaced with a partial condenser and the content was again heated to allow the reaction liquid temperature to reach 120°C over 3 hours while by-product methanol and condensation water being recovered. When the reaction liquid temperature reached 120°C, 7.9 g of pyridine was added, and the content was heated as it was to allow the reaction liquid temperature to reach 160°C over 3 hours while condensation water being recovered, and kept at the same temperature for 2 hours and cooled to room temperature.

The reaction product, in which the non-volatile content was 74.3%, was a seal brown, high-viscosity liquid (the reaction product liquid was referred to as "silane compound solution 1"), and the molecular weights thereof were measured by GPC to be found that the number average molecular weight was 2041 and the weight average molecular weight was 2838. The reaction product was subjected to 1H-NMR and 13C-NMR measurements, and was confirmed to contain a compound (poly[(cis-4-cyclohexene-1,2-imido)propylsilsesquioxane]) represented by the following chemical formula:

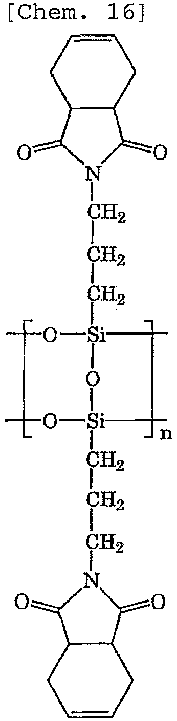

1H-NMR: 0.25-0.55 (bs, 2H), 1.3-1.5 (bs, 2H), 2.0-2.5 (dd, 4H), 2.9-3.1 (bs, 2H), 3.2-3.35 (bs, 2H), 5.65-5.8 (bs, 2H) 13C-NMR: 10.0, 21.0, 23.8, 39.0, 41.1, 127.8, 180.5

### Synthesis Example 2 (silane compound solution 2)

### Synthesis of poly{γ-(5-norbornene-2,3-imido)propylsilsesquioxane}

A 300-mL four-necked flask equipped with a stirring apparatus, a temperature sensor and a condenser tube was charged with 35.1 g of diglyme previously dried by a molecular sieve and 30.8 g of 3-aminopropyl trimethoxysilane, and the content was heated to 100°C under a dry nitrogen flow with being stirred, to remove moisture in the system. Then, 28.2 g of 5-norbornene-2,3-dicarboxylic anhydride was added therein in four portions over 30 minutes while the reaction liquid temperature was kept at 100°C. At 9 hours after the completion of charging, it was confirmed by high-performance liquid chromatography that 5-norbornene-2,3-dicarboxylic anhydride was completely consumed.

Subsequently, 9.3 g of deionized water was added at one time, the content was heated so that the reflux of by-product methanol occurred by the condenser tube, and held at 95°C for 10 hours, thereafter the condenser tube was replaced with a partial condenser, and the content was again heated to allow the reaction liquid temperature to reach 120°C over 3 hours while by-product methanol and condensation water being recovered. When the reaction liquid temperature reached 120°C, 1.4 g of pyridine was added, and the content was heated as it was to allow the reaction liquid temperature to reach 160°C over 3 hours while condensation water being recovered, and kept at the same temperature for 2 hours and cooled to room temperature.

The reaction product, in which the non-volatile content was 58.2%, was a seal brown, high-viscosity liquid (the reaction product liquid was referred to as "silane compound solution 2"), and the molecular weights thereof were measured by GPC to be found that the number average molecular weight was 2340 and the weight average molecular weight was 2570. The reaction product was subjected to 1H-NMR and 13C-NMR measurements, and was confirmed to contain a compound (poly{γ-(5-norbornene-2,3-imido)propylsilsesquioxane}) represented by the following chemical formula:

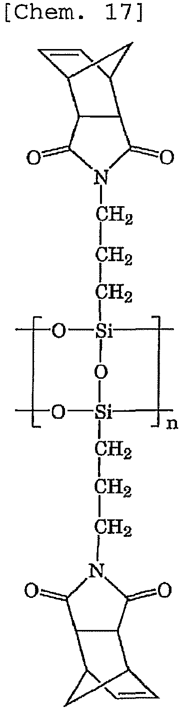

1H-NMR: 0.25-0.45 (bs, 2H), 1.2-1.45 (bs, 2H), 1.47 (dd, 2H), 3.0-3.2 (bs, 4H), 3.4-3.6 (bs, 2H), 5.8-6.0 (bs, 2H) 13C-NMR: 9.7, 21.5, 40.4, 44.9, 45.7, 50.1, 134.2, 178.0

Herein, the poly{γ-(5-norbornene-2,3-imido)propylsilsesquioxane} was more specifically presumed to be a compound represented by the following chemical formula.

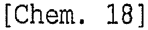

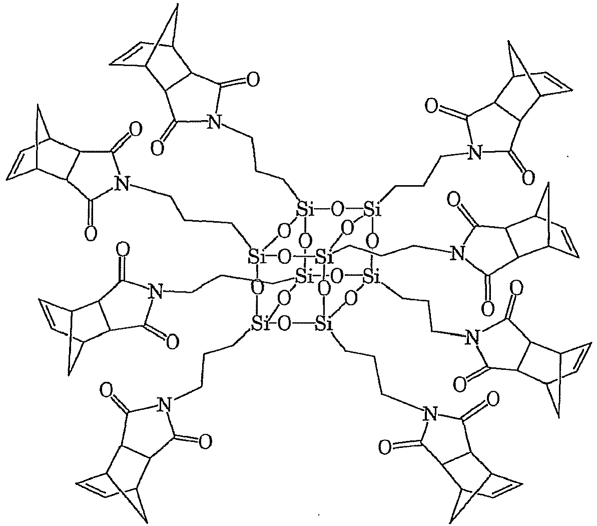

### Synthesis Example 3 (silane compound solution 3)

### Synthesis of hydrolysis co-condensation product of γ-(5-norbornene-2,3-imido)propyltrimethoxysilane and tetramethoxysilane

A 300-mL four-necked flask equipped with a stirring apparatus, a temperature sensor and a condenser tube was charged with 98 g of N,N'-dimethylformamide previously dried by a molecular sieve, 58.0 g of 3-aminopropyl trimethoxysilane and 49.2 g of tetramethoxysilane, and the content was heated to 100°C under a dry nitrogen flow with being stirred, to remove moisture in the system. Then, 53.6 g of 5-norbornene-2,3-dicarboxylic anhydride was added therein in four portions over 30 minutes while the reaction liquid temperature was kept at 100°C. At 9 hours after the completion of charging, it was confirmed by high-performance liquid chromatography that 5-norbornene-2,3-dicarboxylic anhydride was completely consumed.

Subsequently, 40.8 g of deionized water was added at one time, the content was heated so that the reflux of by-product methanol occurred by the condenser tube, and held at 95°C for 10 hours, thereafter the condenser tube was replaced with a partial condenser, and the content was again heated to allow the reaction liquid temperature to reach 120°C over 3 hours while by-product methanol and condensation water being recovered. When the reaction liquid temperature reached 120°C, 1.4 g of pyridine was added, and the content was heated as it was to allow the reaction liquid temperature to reach 160°C over 3 hours while condensation water being recovered, and kept at the same temperature for 2 hours and cooled to room temperature.

The reaction product, in which the non-volatile content was 60.3%, was a seal brown, high-viscosity liquid (the reaction product liquid was referred to as "silane compound solution 3"). The reaction product was subjected to 1H-NMR and 13C-NMR measurements, and the following peaks were observed. Therefore, the product was confirmed to contain a γ-(5-norbornene-2,3-imido)propyl group.
1H-NMR: 0.25-0.45 (bs, 2H), 1.2-1.45 (bs, 2H), 1.47 (dd, 2H), 3.0-3.2 (bs, 4H), 3.4-3.6 (bs, 2H), 5.8-6.0 (bs, 2H) 13C-NMR: 9.7, 21.5, 40.4, 44.9, 45.7, 50.1, 134.2, 178.0

The particle size distribution of the product was further measured using a particle size distribution measuring apparatus (apparatus name: LB-500, manufactured by Horiba Ltd.), and it was confirmed that the product was of nanoparticles having an average particle size of 8 nm.

### Preparation Examples 1-1 to 1-9

Each of aromatic amine compounds listed in Table 1 was dissolved in the silane compound solution obtained in each of Synthesis Examples, and thereafter a solvent component was removed using an evaporator to take out each of solid contents (compositions 1-1 to 1-8). The melting point (°C) of each of the resulting solid content was measured using DSC, and the softening point (°C) thereof was measured using a heat softening temperature measuring apparatus. The types and amounts of the silane compound solution and the aromatic amine compound used in each of Preparation Examples, and the measurement results are shown in Table 1. Herein, only the aromatic amine compound (aromatic amine 6) was evaluated as composition 1-9 in Preparation Example 1-9.

**[Table 1]**

| | | | Preparation Example 1-1 | Preparation Example 1-2 | Preparation Example 1-3 | Preparation Example 1-4 | Preparation Example 1-5 | Preparation Example 1-6 | Preparation Example 1-7 | Preparation Example 1-8 | Preparation Example 1-9 |
|---|---|---|---|---|---|---|---|---|---|---|---|
| Composition name | | | Composition 1-1 | Composition 1-2 | Composition 1-3 | Composition 1-4 | Composition 1-5 | Composition 1-6 | Composition 1-7 | Composition 1-8 | Composition 1-9 |
| Silane compound solution (unit: part) | Silane compound solution 1 | | - | - | - | - | - | 107 | - | - | - |
| | Silane compound solution 2 | | 137 | 105 | 122 | 95 | 154 | - | - | 135 | - |
| | Silane compound solution 3 | | - | - | - | - | - | - | 132 | - | - |
| Aromatic amine compound (unit: part) | Aromatic amine 1 | Melting point 176°C | 50 | - | - | - | - | 50 | 50 | - | - |
| | Aromatic amine 2 | Melting point 196°C | - | 50 | - | - | - | - | - | - | - |
| | Aromatic amine 3 | Melting point 117°C | - | - | 50 | - | - | - | - | - | - |
| | Aromatic amine 4 | Melting point 132°C | - | - | - | 50 | - | - | - | - | - |
| | Aromatic amine 5 | Melting point 102°C | - | - | - | - | 50 | - | - | - | - |
| | Aromatic amine 6 | N/A (Liquid at room temperature) | - | - | - | - | - | - | - | 50 | 50 |
| Melting point (°C) | | | Disappear | Disappear | Disappear | Disappear | Disappear | Disappear | Disappear | N/A (Liquid at room temperature) | N/A (Liquid at room temperature) |
| Softening point (°C) | | | 89 | 93 | 76 | 80 | 83 | 84 | 92 | 95 | N/A (Liquid at room temperature) |

| | | | | | | | | | | | |
|---|---|---|---|---|---|---|---|---|---|---|---|
| Aromatic amines 1 to 6 listed in Table 1 are as follows. Aromatic amine 1: bis(4-aminophenyl)sulfide, melting point: 176°C Aromatic amine 2: 4,4'-bis(4-aminophenoxy)biphenyl, melting point: 196°C Aromatic amine 3: 1,3-bis(4-aminophenoxy)benzene, melting point: 117°C Aromatic amine 4: bis[4-(3-aminophenoxy)phenyl]sulfone, melting point: 132°C Aromatic amine 5: 2,2'-dimethyl-4,4'-diaminobiphenyl, melting point: 102°C Aromatic amine 6: condensate of 2-ethylaniline and formaldehyde (product name "Kayahard A-A", produced by Nippon Kayaku Co., Ltd.), liquid at room temperature | | | | | | | | | | | |

As shown in Table 1, aromatic amines 1 to 5 used in Preparation Examples 1-1 to 1-7, but all having a melting point of more than 100°C, had the silane compound mixed therewith to thereby allow the melting point of the silane-containing composition including them to disappear and allow the composition to be softened at a temperature equal to or lower than the melting point of the aromatic amine compound. This means that the silane compound was mixed to thereby decrease the useable lower limit temperature and make processability higher. On the other hand, aromatic amine 6 was a liquid compound at room temperature as clear from the result in Preparation Example 1-9, namely, a compound having no melting point. As shown in Preparation Example 1-8, such aromatic amine 6 was mixed with the silane compound to thereby be solidified at room temperature, exhibiting the softening point. This means that the silane compound was mixed to thereby increase the useable lower limit temperature and make processability lower.

### <Preparations and Evaluations of Curable Resin Compositions>

### Preparation Examples 1-10 to 1-18

Components were mixed in each composition in Table 2 by using a twin-screw kneading extruder to provide a uniform resin composition.

The resulting resin composition was formed into a resin cured product by using a transfer molding machine. The resin curing temperature at the time of preparing a test piece was as follows: 170°C × 3 minutes + 250°C × 3 hours. Thermal characteristics of the resulting test piece were evaluated using a dynamic viscoelasticity measuring apparatus (DMA) and a thermomechanical analysis apparatus (TMA), and mechanical characteristics thereof were evaluated by bending strength measurement using Instron. The results are shown in Table 2.

**[Table 2]**

| | | | | Preparation Example 1-10 | Preparation Example 1-11 | Preparation Example 1-12 | Preparation Example 1-13 | Preparation Example 1-14 | Preparation Example 1-15 | Preparation Example 1-16 | Preparation Example 1-17 | Preparation Example 1-18 |
|---|---|---|---|---|---|---|---|---|---|---|---|---|
| Resin composition name | | | | Resin Composition 1-1 | Resin Composition 1-2 | Resin Composition 1-3 | Resin Composition 1-4 | Resin Composition 1-5 | Resin Composition 1-6 | Resin Composition 1-7 | Resin Composition 1-8 | Resin Composition 1-9 |
| Epoxy group-containing compound 1 | | | Part | 5.33 | 4.69 | 5.08 | 4.41 | 5.55 | 5.33 | 5.33 | 5.30 | 8.83 |
| Composition 1-1 | | | Part | 5.40 | - | - | - | - | - | - | - | - |
| Composition 1-2 | | | Part | - | 6.04 | - | - | - | - | - | - | - |
| Composition 1-3 | | | Part | - | - | 5.65 | - | - | - | - | - | - |
| Composition 1-4 | | | Part | - | - | - | 6.32 | - | - | - | - | - |
| Composition 1-5 | | | Part | - | - | - | - | 5.17 | - | - | - | - |
| Composition 1-6 | | | Part | - | - | - | - | - | 5.40 | - | - | - |
| Composition 1-7 | | | Part | - | - | - | - | - | - | 5.40 | - | - |
| Composition 1-8 | | | Part | - | - | - | - | - | - | - | 5.44 | - |
| Composition 1-9 | | | Part | - | - | - | - | - | - | - | - | 3.53 |
| Curing accelerator | | | Part | 0.08 | 0.08 | 0.08 | 0.08 | 0.08 | 0.08 | 0.08 | 0.08 | 0.08 |
| Imide compound | | | Part | 1.62 | 1.62 | 1.62 | 1.62 | 1.62 | 1.62 | 1.62 | 1.62 | 1.62 |
| Flame retardant | | | Part | 1.45 | 1.45 | 1.45 | 1.45 | 1.45 | 1.45 | 1.45 | 1.45 | 1.45 |
| Silica | | | Part | 85.00 | 85.00 | 85.00 | 85.00 | 85.00 | 85.00 | 85.00 | 85.00 | 85.00 |
| Carbon black | | | Part | 0.14 | 0.14 | 0.14 | 0.14 | 0.14 | 0.14 | 0.14 | 0.14 | 0.14 |
| Thermal characteristics | TMA | Tg | °C | 250 | 274 | 270 | 261 | 285 | 248 | 253 | 235 | 230 |
| | | CTE1 | ppm | 13 | 12 | 13 | 13 | 13 | 13 | 12 | 13 | 13 |
| | | CTE2 | ppm | 38 | 40 | 42 | 38 | 42 | 38 | 35 | 40 | 40 |
| | DMA | Tg | °C | 290 | 313 | 310 | 303 | 319 | 285 | 295 | 270 | 265 |
| Mechanical strength | Bending strength | | Mpa | 150 | 145 | 143 | 164 | 147 | 152 | 148 | 130 | 119 |
| | Bending modelasticulus | | Gpa | 24.8 | 22.8 | 21.7 | 24.3 | 21.9 | 23.6 | 23.1 | 20.8 | 20.2 |

| | | | | | | | | | | | | |
|---|---|---|---|---|---|---|---|---|---|---|---|---|
| Respective components and symbols listed in Table 2 are as follows. Epoxy group-containing compound 1: polyfunctional epoxy resin (product name "EPPN-501HY", produced by Nippon Kayaku Co., Ltd.) Curing accelerator: 2-ethyl-4-methylimidazole Imide compound (bismaleimide compound): 4,4'-diphenylmethanebismaleimide (product name "BMI-1100H", produced by Daiwa Kasei Co., Ltd.) Flame retardant: aromatic phosphate (product name "PX-200", produced by Daihachi Chemical Industry Co., Ltd.) CTE 1: expansion coefficient equal to or lower Tg CTE 2: expansion coefficient equal to or higher Tg | | | | | | | | | | | | |

As shown in Table 2, the cured products obtained in Preparation Examples 1-10 to 1-16 were remarkably high in glass transition temperature and extremely excellent in mechanical strength as compared with the cured products obtained in Preparation Examples 1-17 and 1-18. In particular, they exhibited a Tg about or higher than 250°C even in TMA measurement, and suggested the heat history in CTE 1 region even in a high temperature operation semiconductor element.

### Preparation Example 2-1 to 2-5

Diaminodiphenylsulfone was mixed with silane compound solution 2 obtained in Synthesis Example 2 so that the proportion was as listed in Table 3 on the solid content basis, heated to 160°C and dissolved therein, and then the solvent component was removed under reduced pressure to provide a solid in which the silane compound (silsesquioxane) and diaminodiphenylsulfone were uniformly mixed.

The resulting solid and a mixture of the remaining raw materials shown in Table 3 were mixed using a three-roll kneader heated to 80°C for 3 minutes, to prepare a resin composition. The resulting resin composition was pulverized, and then subjected to pressure molding (pressure forming) using a heat press shaping machine at 175°C for 3 minutes, to provide a planar shaped article having a size of 90 mm × 60 mm × 4mm. The resulting shaped article was cut so as to have a size of 80 mm × 10 mm × 4mm, and a three-point bending test was performed using the Instron universal tester piece to measure the elastic modulus and the bending strength. In addition, the resulting shaped article was cut into a test piece having a size of 5 mm × 5 mm × 10 mm, and a thermomechanical measuring apparatus (TMA4000SA, manufactured by Bruker) was used to measure the glass transition temperature (Tg). The results are shown in Table 3. Herein, the unit of the amount of each component mixed in each of the resin compositions in Table 3 was part(s) (part(s) by weight).

**[Table 3]**

| | | Preparation Example 2-1 | Preparation Example 2-2 | Preparation Example 2-3 | Preparation Example 2-4 | Preparation Example 2-5 |
|---|---|---|---|---|---|---|
| Resin formulation (unit: part) | Silane compound | 2.6 | 2.6 | 2.5 | 2.6 | - |
| | Silicone rubber fine particle A | 2 | - | 2 | - | - |
| | Silicone rubber fine particle B | - | - | - | 1 | - |
| | Silicone oil A | - | 1 | 1 | - | - |
| | Silicone oil B | - | - | - | 1 | - |
| | Imide compound | 1.3 | 1.3 | 1.2 | 1.3 | - |
| | Epoxy resin | 7.4 | 7.4 | 6.9 | 7.4 | 10.5 |
| | Phenol resin | 2 | 2 | 2 | 2 | 6.5 |
| | Aromatic amine compound | 1.7 | 1.7 | 1.5 | 1.7 | - |
| | Silica filling material | 82 | 82 | 82 | 82 | 82 |
| | Curing accelerator | 0.1 | 0.1 | 0.1 | 0.1 | 0.1 |
| | Colorant | 0.2 | 0.2 | 0.2 | 0.2 | 0.2 |
| | Coupling agent | 0.2 | 0.2 | 0.2 | 0.2 | 0.2 |
| | Release agent | 0.5 | 0.5 | 0.5 | 0.5 | 0.5 |
| Properties of cured product | Elastic modulus [GPa] | 16.4 | 16.5 | 13.5 | 14.5 | 20.1 |
| | Bending strength [MPa] | 115 | 112 | 90 | 105 | 124 |
| | Glass transition temperature [°C] | 248 | 240 | 242 | 241 | 201 |

| | | | | | | |
|---|---|---|---|---|---|---|
| Respective components listed in Table 3 are as follows. Silicone rubber fine particle A: KMP-605 (produced by Shin-Etsu Chemical Co., Ltd.) Silicone rubber fine particle B: EP-2610 (produced by Dow Corning Toray Co., Ltd.) Silicone oil A: SF8421 (produced by Dow Corning Toray Co., Ltd.) Silicone oil B: SF8417 (produced by Dow Corning Toray Co., Ltd.) Imide compound: BMI2300 (polyphenylmethane maleimide, produced by Daiwa Kasei Co., Ltd.) Epoxy resin: EPPN-501HY (tris(hydroxyphenyl)methane epoxy resin, produced by Nippon Kayaku Co., Ltd.) Phenol resin (phenol curing agent): TD-2131 (phenol novolac resin, produced by DIC Corporation) Aromatic amine compound (amine curing agent): Seikacure S (4,4'-diaminodiphenylsulfone (melting point: 176°C), produced by Seika Corporation) Silica filling material (fused silica): S270 (produced by Nippon Steel Materials Co., Ltd.) Curing accelerator: 2P4MHZ-PW (2-phenyl-4-methyl-5-hydroxymethylimidazole, produced by Shikoku Chemicals Corporation) Colorant: carbon black Coupling agent: KBM-403 (3-glycidoxypropyltrimethoxysilane, produced by Shin-Etsu Chemical Co., Ltd.) Release agent: carnauba wax | | | | | | |

### Preparation Examples 3-1, 3-2, 3-4 and 3-5

Components were mixed in each composition shown in Table 4 below by using a three-roll kneader heated to 80°C for 3 minutes, to provide a resin composition. This resin composition was pulverized, and then formed into a tablet.

The resulting tablet was used to measure the melt viscosity at 175°C by using a flow tester (CFT-500D, manufactured by Shimadzu Corporation).

### Preparation Example 3-3

Epoxy resin B, an acid anhydride curing agent and a silane compound (silsesquioxane) were heated and stirred in the composition shown in Table 4 below at 80°C for 1 hour to prepare a solution, and the solution was mixed with a filling material and various additives by a planetary mixer at room temperature to provide a resin composition.

The viscosity at 60°C of the resulting liquid resin composition was measured using a dynamic viscoelasticity measuring apparatus (HR-1, manufactured by TA Instruments Japan).

Herein, the unit of the amount of each component blended in each of the resin compositions in Table 4 was part(s) by mass.

In addition, measurement conditions of the respective physical properties in each Preparation Example shown in Table 4 are as follows.

### (1) Melting and mixing

When the respective components were added, heated and mixed, the case where they could be molten and mixed was rated as "Good", and the case where they could not be compatible with one another and could not be uniformly mixed was rated as "Bad".

### (2) Tg

The resin composition obtained in each Preparation Example was used to form a test piece having a size of 5 × 5 × 10 mm. Then, a thermomechanical measuring apparatus (TMA4000SA, manufactured by Bruker) was used to apply a load of 10 g to this test piece for measurement.

### (3) Flame Retardance

The flame retardance was measured using a flame retardance tester (manufactured by Suga Test Instruments Co., Ltd.) according to UL-94 Standard. Herein, the flame retardance indicated by V-0 was higher than that indicated by V-1.

**[Table 4]**

| | | Preparation Example 3-1 | Preparation Example 3-2 | Preparation Example 3-3 | Preparation Example 3-4 | Preparation Example 3-5 |
|---|---|---|---|---|---|---|
| Resin formulation (unit: part) | Epoxy resin A | 7.5 | 8.4 | - | 8.4 | 12.4 |
| | Epoxy resin B | - | - | 6.6 | - | - |
| | Phenol resin | - | 2.3 | - | 2.3 | - |
| | Aromatic amine compound | 2.8 | 1.8 | - | 1.8 | 4.6 |
| | Acid anhydride curing agent | - | - | 10.9 | - | - |
| | Silane compound | 4.5 | 3.0 | 2.0 | 3.0 | - |
| | Imide compound | 2.2 | 1.5 | - | 1.5 | - |
| | Silica filling material | 78.0 | 78.0 | 72.0 | 82.0 | 78.0 |
| | Composite metal hydroxide | 4.0 | 4.0 | 8.0 | - | 4.0 |
| | Curing accelerator | 0.1 | 0.1 | 0.1 | 0.1 | 0.1 |
| | Colora nt | 0.2 | 0.2 | 0.2 | 0.2 | 0.2 |
| | Coupling agent | 0.2 | 0.2 | 0.2 | 0.2 | 0.2 |
| | Release agent | 0.5 | 0.5 | - | 0.5 | 0.5 |
| Physical properties of cured product | Melting and mixing availability | Good | Good | Good | Good | Bad |
| | Viscosity at 175°C [Pa·s] | 32.1 | 17.2 | - | 72 | - |
| | Viscosity at 60°C [Pa·s] | - | - | 8.3 | - | - |
| | Tg(°C) | 250 | 248 | 240 | 245 | - |
| | Flame Retardance | V-0 | V-0 | V-0 | V-1 | V-0 |

| | | | | | | |
|---|---|---|---|---|---|---|
| Respective components listed in Table 4 above are as follows. Epoxy resin A: tris(hydroxyphenyl)methane epoxy resin, melting point: 55°C (EPPN-501HY, produced by Nippon Kayaku Co., Ltd.) Epoxy resin B: triglycidyl isocyanurate, melting point: 120°C (TEPIC-S, produced by Nissan Chemical Industries Ltd.) Phenol resin (phenol curing agent): phenol novolac resin, melting point: 80°C (TD-2131, produced by DIC Corporation) Aromatic amine compound (amine curing agent): 4,4'-diaminodiphenylsulfone, melting point: 176°C (Seikacure S, produced by Seika Corporation) Acid anhydride curing agent: methyltetrahydrophthalic anhydride, liquid (HN-2000, produced by Hitachi Chemical Co., Ltd.) Silane compound (silsesquioxane): the compound prepared in Synthesis Example 2 Imide compound: polyphenylmethane maleimide (BMI2300, produced by Daiwa Kasei Co., Ltd.) Silica filling material: fused silica (S270, produced by Nippon Steel Materials Co., Ltd.) Composite metal hydroxide: magnesium-zinc composite hydroxide (Z-10, produced by Tateho Chemical Industries Co., Ltd.) Curing accelerator: 2-phenyl-4-methyl-5-hydroxymethylimidazole (2P4MHZ-PW, produced by Shikoku Chemicals Corporation) Colorant: carbon black Coupling agent: 3-glycidoxypropyltrimethoxysilane (KBM-403, produced by Shin-Etsu Chemical Co., Ltd.) Release agent: carnauba wax | | | | | | |

From the results in Table 4, the components could be mixed with no problem in all of Preparation Examples 3-1 to 3-4. On the other hand, the components could not be molten and kneaded in Preparation Example 3-5 because the silane compound was not included. In addition, all of the resin compositions in Preparation Examples 3-1, 3-2 and 3-3 had high Tg and were excellent in heat resistance. Furthermore, in Preparation Examples 3-1 to 3-3 where the silica and the composite metal hydroxide were used at the same time, the viscosity of the curable resin composition could be appropriate and also exhibited excellent flame retardance. It was thus found that the silica and the composite metal hydroxide were preferably used at the same time in an application requiring for a low viscosity and high flame retardance. It was also found from these results that the silica and the composite metal hydroxide were suitably used as the inorganic filling material at the same time in the curable resin composition of the present invention to thereby provide a curable resin composition having better fluidity, heat resistance and flame retardance, and being more useful as a sealing material of an electronic component or the like.

### Preparation Examples 4-1 to 4-3

First, an aromatic amine compound (amine curing agent) was added in silane compound solution 2 obtained in Synthesis Example 2, and a solvent component was removed under reduced pressure with being heated and stirred at 150°C for 2 hours, thereby providing a silane-containing composition in which the aromatic amine compound and silane compound were uniformly dispersed. The composition was mixed with other resin composition raw materials shown in Table 5 at 80°C, and the resultant was subjected to compression molding using a heat press shaping machine at 175°C for 6 minutes. The resulting shaped product was cured at 250°C for 3 hours to provide a cured product. The resulting cured product was subjected to TMA measurement to measure the glass transition temperature (Tg), and subjected to a three-point bending test using the Instron universal tester to measure the elastic modulus and the bending strength. The results are shown in Table 5.

### Preparation Example 4-4

Resin composition raw materials shown in Table 5 were mixed at 80°C, and subjected to compression molding using a heat press shaping machine at 175°C for 6 minutes. The resulting shaped product was cured at 250°C for 3 hours to provide a cured product. The resulting cured product was used to measure the glass transition temperature (Tg), the elastic modulus and the bending strength in the same manner as in Preparation Examples 4-1 to 4-3. The results are shown in Table 5.

**[Table 5]**

| | | Preparation Example 4-1 | Preparation Example 4-2 | Preparation Example 4-3 | Preparation Example 4-4 |
|---|---|---|---|---|---|
| Resin formulation (unit: part) | Epoxy resin | 7.1 | 7.0 | 6.8 | 4.9 |
| | Phenol resin A | 2.0 | - | 1.9 | 3.0 |
| | Phenol resin B | - | 3.6 | 1.2 | - |
| | Aromatic amine compound | 1.6 | 1.5 | 0.8 | - |
| | Silane compound | 2.5 | 2.5 | 1.6 | 3.5 |
| | Silica component | 82 | 82 | 84 | 85 |
| | Imide component | 1.2 | 1.2 | 0.3 | 1.7 |
| Properties of cured product | Glass transition temperature (Tg) [°C] | 248 | 243 | 230 | 173 |
| | Elastic modulus [GPa] | 17.1 | 16.2 | 16.1 | 20.4 |
| | Bending strength [MPa] | 124 | 121 | 126 | 113 |

| | | | | | |
|---|---|---|---|---|---|
| A silica component listed in Table 5 was fused silica. Respective components other than the silica component are as follows. The silane compound used was one synthesized in Synthesis Example 2. Epoxy resin: tris(hydroxyphenyl)methane epoxy resin (EPPN-501HY, produced by Nippon Kayaku Co., Ltd.) Phenol resin A (phenol curing agent a): phenol novolac curing agent (TD-2131, produced by DIC Corporation) Phenol resin B (phenol curing agent b): polyfunctional phenol curing agent (MEH-7500, produced by Meiwa Plastic Industries Ltd.) Aromatic amine compound (amine curing agent): 4,4'-diaminodiphenylsulfone (Seikacure S, melting point: 176°C, produced by Seika Corporation) Imide component: polyphenylmethane maleimide (BMI2300, produced by Daiwa Kasei Co., Ltd.) | | | | | |

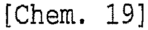

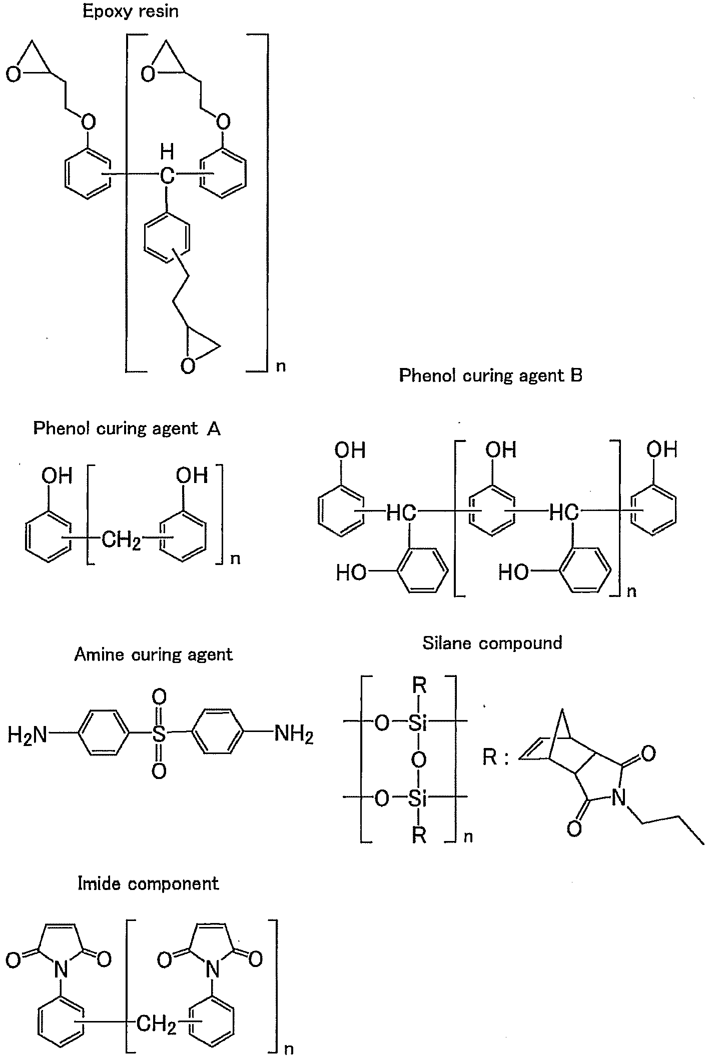

It was confirmed from the results in Table 5 that the cured product obtained from the resin composition in each of Preparation Examples 4-1 to 4-3 in which the phenol resin and the aromatic amine compound were used at the same time was a cured product that was flexible and high in strength while keeping high Tg and a high heat resistance. On the other hand, it was confirmed that the cured product in Preparation Example 4-4 in which only the phenol curing agent was used was lower in Tg and lower in heat resistance than those in each of Preparation Examples 4-1 to 4-3.

### Preparation Examples 5-1 and 5-2

Each of compositions shown in Table 6 below was mixed at 80°C, and subjected to compression molding at 175°C for 6 minutes. The resulting molded product was used to provide each of a sample cured at 250°C for 3 hours (Preparation Example 5-1) and a sample cured at 150°C for 5 hours (Preparation Example 5-2).

With respect to each of these cured samples, the glass transition temperature (Tg) was determined using a thermomechanical analysis apparatus (TMA4000SA, manufactured by Bruker AXS). In addition, cracking of each of the cured samples was visually observed using loupe (Good: no cracking, Bad: cracking). These results are shown in Table 7.

**[Table 6]**

| | Amont (part) |
|---|---|
| Epoxy resin | 5.8 |
| Aromatic amine compound | 2.3 |
| Silane compound | 3.6 |
| Imide component | 1.8 |
| Silica | 85 |

| | |
|---|---|
| Respective compounds listed in Table 6 above are as follows. Epoxy resin: tris(hydroxyphenyl)methane epoxy resin (EPPN-501HY, produced by Nippon Kayaku Co., Ltd.) Aromatic amine compound (curing agent): 4,4'-diaminodiphenylsulfone, melting point: 176°C (Seikacure S, produced by Seika Corporation) Silane compound: the compound prepared in Synthesis Example 2 Imide component: polyphenylmethane maleimide (BMI2300, produced by Daiwa Kasei Co., Ltd.) Silica: fused silica (S270, produced by Nippon Steel Materials Co., Ltd.) | |

**[Table 7]**

| | Preparation Example 5-1 | Preparation Example 5-2 |
|---|---|---|
| Curing condition | 250°C × 3 hours | 150°C × 5 hours |
| Tg(°C) | 233 | 190 |
| Cracking | Good | Good |

It was found from the results in Table 7 that the cured product obtained in Preparation Example 5-1 could have a high Tg of 40°C or higher and an extremely excellent heat resistance as compared with that obtained in Preparation Example 5-2, and could have no cracking.

It has been thus found that the method for producing a cured product, including a step of subjecting the curable resin composition to molding and a step of post-curing the resulting molded product, wherein a temperature at the post-curing is higher than a molding temperature by 30°C or higher, according to the present invention, can be used to thereby provide a cured product having a high heat resistance of 200°C or higher and being excellent in mechanical strength. It is herein considered that such a mechanism is applied in the same manner as long as the production method is used in which the curable resin composition of the present invention is used.

## Claims

1. A silane-containing composition comprising an aromatic amine compound and a silane compound,
wherein the aromatic amine compound is a compound having a melting point of 100°C or higher, and
the silane compound has a siloxane bond and is represented by the following average composition formula (1):
XₐY_{b}Z_{c}SiO_{d} (1)
wherein each X is the same or different and represents an organic backbone including an imide bond, each Y is the same or different and represents at least one selected from the group consisting of a hydrogen atom, a hydroxyl group, a halogen atom and an OR group, each R is the same or different, represents at least one group selected from the group consisting of an alkyl group, an acyl group, an aryl group and an unsaturated aliphatic residue, and optionally has a substituent, each Z is the same or different and represents an organic backbone including no imide bond, a is 0 or a number of less than 3, b is 0 or a number of less than 3, c is 0 or a number of less than 3, d is a number of less than 2 but not 0, and a + b + c + 2d = 4 is satisfied.

2. The silane-containing composition according to claim 1, further comprising a silicone rubber and/or a silicone oil,
wherein X in the average composition formula (1) is a group represented by the following formula (3) and a is a number of less than 3 but not 0: 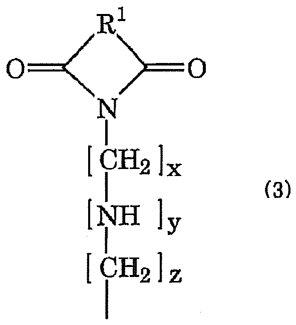 wherein R¹ represents at least one structure selected from the group consisting of an aromatic, a heterocyclic ring and an alicyclic ring, and optionally has a substituent, x and z are the same or different and are an integer of 0 or more and 5 or less, and y is 0 or 1.

3. The silane-containing composition according to claim 1 or 2, which is a sealing material composition.

4. A method for producing the silane-containing composition according to any of claims 1 to 3, the method comprising
a step of dissolving the aromatic amine compound in a silane compound solution including the silane compound and a solvent, and then removing the solvent.

5. A curable resin composition comprising the silane-containing composition according to any of claims 1 to 3, an epoxy resin and an inorganic filling material.

6. The curable resin composition according to claim 5, further comprising a phenol resin.

7. The curable resin composition according to claim 5 or 6,
wherein the inorganic filling material comprises silica and a composite metal hydroxide.

8. A method for producing a cured product from the curable resin composition according to any of claims 5 to 7, the method comprising
a step of subjecting the curable resin composition to molding, and
a step of post-curing the resulting molded product,
wherein a temperature at the post-curing is higher than a molding temperature by 30°C or higher.

9. A sealing material obtained by using the curable resin composition according to any of claims 5 to 7.
